# EUROPÄISCHE PATENTSCHRIFT

(11) **EP 3 450 915 B1**
(45) Veröffentlichungstag und Bekanntmachung des Hinweises auf die Patenterteilung: **25.11.2020**
(21) Anmeldenummer: 17188474.5
(22) Anmeldetag: 30.08.2017
(51) Int. Cl.: G01C 15/00, G01S 7/481, G01S 17/89, G01S 17/10, G01S 17/42, G01S 7/4863

(54) **TOTALSTATION ODER THEODOLIT MIT SCANFUNKTIONALITÄT UND EINSTELLBAREN EMPFANGSBEREICHEN DES EMPFÄNGERS**
TOTAL STATION OR THEODOLITE WITH SCAN FUNCTIONALITY AND ADJUSTABLE RECEIVING AREAS OF THE RECEIVER
TACHÉOMÈTRE ÉLECTRONIQUE OU THÉODOLITE POURVUS DE FONCTION DE BALAYAGE ET DE ZONES DE RÉCEPTION RÉGLABLES DU RÉCEPTEUR

(43) Veröffentlichungstag der Anmeldung: 06.03.2019
(73) Patentinhaber: Hexagon Technology Center GmbH, 9435 Heerbrugg (CH)
(72) Erfinder: MAYER, Tim, CH-9326 Horn (CH); HINDERLING, Jürg, CH-9437 Marbach (CH)
(74) Vertreter: Kaminski Harmann

(56) Entgegenhaltungen:
- EP-A1- 3 098 564
- EP-A2- 3 077 768
- US-A1- 2012 249 998
- US-A1- 2016 084 651

## Beschreibung

Die Erfindung bezieht sich auf eine Totalstation oder einen Theodoliten mit Scanfunktionalität zur optischen Vermessung einer Umgebung.

Totalstationen oder Theodoliten mit Scanfunktionalität werden beispielsweise verwendet, um 3D-Koordinaten von Oberflächen zu messen bzw. zu erstellen. Zu diesem Zweck müssen sie in der Lage sein, den Messstrahl - meist ein Laserstrahl - einer Entfernungsmessvorrichtung über eine Oberfläche zu führen und damit bei einer vorgegebenen Abtast- oder Messrate sukzessive zu verschiedenen Messrichtungen gleichzeitig Richtung und Entfernung zum jeweiligen Messpunkt zu erfassen. Richtung und Entfernung sind dabei bezogen auf einen Messbezugspunkt wie z.B. der Standort oder Nullpunkt des Vermessungsgeräts, liegen mit anderen Worten in einem gemeinsamen Bezugs- oder Koordinatensystem, so dass also die einzelnen Messrichtungen und damit die Einzelmessdaten über den gemeinsamem Messbezugspunkt miteinander verknüpft sind. Aus dem Entfernungsmesswert und der damit korrelierten Messrichtung für jeden Punkt kann somit anschliessend, beispielsweise mittels einer integrierten oder externen Datenverarbeitungsanlage aus der Vielzahl der gescannten Punkte eine sogenannte 3D-Punktwolke generiert werden.

Vom prinzipiellen Aufbau her sind derartige Totalstationen oder Theodoliten beispielsweise mit einem elektro-optischen laserbasierten Entfernungsmesser ausgebildet, um eine Distanz zu einem Objektpunkt als Messpunkt zu erfassen, wobei zudem eine Richtfunktionalität vorhanden ist, um die Senderichtung des Entfernungsmessstrahls zu variieren, beispielsweise bezüglich einer oder mehrerer unabhängiger Raumrichtungen, wodurch ein räumlicher Mess- oder Abtastbereich erfasst werden kann.

Im Bereich der elektronischen bzw. elektrooptischen Distanzmessung sind verschiedene Prinzipien und Verfahren bekannt. Ein Ansatz besteht darin, gepulste elektromagnetische Strahlung, wie z.B. Laserlicht, auf ein zu vermessendes Ziel auszusenden und nachfolgend ein Echo von diesem Ziel als rückstreuendem Objekt zu empfangen, wobei die Distanz zum zu vermessenden Ziel beispielsweise anhand der Laufzeit, der Form, und/oder der Phase des Pulses bestimmt werden kann. Solche Laserdistanzmesser haben sich mittlerweile in vielen Bereichen als Standardlösungen durchgesetzt.

Zur Detektion des zurückkommenden Pulses oder einer zurückkommenden Pulsfolge werden zumeist zwei unterschiedliche Ansätze oder eine Kombination daraus verwendet.

Bei der so genannten Schwellwertmethode wird ein Lichtpuls detektiert, wenn die Intensität der auf einen Detektor des eingesetzten Distanzmessgeräts einfallenden Strahlung einen gewissen Schwellwert überschreitet. Durch diesen Schwellwert wird verhindert, dass Rauschen und Störsignale aus dem Hintergrund fälschlich als Nutzsignal, d.h. als rückgestreutes Licht des emittierten Pulses, detektiert werden.

Problematisch ist jedoch, dass bei schwachen rückgestreuten Pulsen, wie sie beispielsweise durch grössere Messdistanzen bedingt werden, eine Detektion nicht mehr möglich ist, wenn die Pulsintensität unter die Detektionsschwelle, d.h. unter den Schwellwert, fällt. Der wesentliche Nachteil dieser Schwellwertmethode liegt somit darin, dass die Amplitude des Messsignals hinreichend grösser als die Rauschamplitude von optischen und elektrischen Rauschquellen im Signalweg sein muss, um Fehldetektionen hinreichend zu minimieren, sodass für Messungen bei relativ grossen Distanzen die Schwellwertmethode nur bedingt einsatztauglich ist.

Der andere Ansatz basiert auf der Abtastung bzw. dem Sampling des rückgestreuten Pulses. Dieser Ansatz wird typischerweise bei schwachen rückgestreuten Signalen (z.B. Pulssignale) verwendet, wie sie beispielsweise durch grössere Messdistanzen bedingt werden. Diese Methode kann auch als ganzheitliche Signalerfassung betrachtet werden, wobei durch das Abtasten sowohl die gesamte Signal- als auch die wesentliche Rauschinformation erfasst werden, was zu einer Erhöhung der Messgenauigkeit führt. Ein emittiertes Signal wird detektiert, indem die von einem Detektor erfasste Strahlung abgetastet, innerhalb des abgetasteten Bereichs ein Signal identifiziert und schliesslich eine Lage des Signals zeitlich bestimmt wird. Durch die Verwendung einer Vielzahl von Abtastwerten und/oder zur Emissionsrate synchronisiertem Aufsummieren des Empfangssignals kann ein Nutzsignal auch unter ungünstigen Umständen identifiziert werden, so dass auch grössere Distanzen oder verrauschte bzw. mit Störungen behaftete Hintergrundszenarien bewältigt werden können.

Heutzutage wird dabei mittels der Wellenformdigitalisierungsmethode ("Waveform Digitizing", WFD) häufig die gesamte Wellenform des analogen Signals der von einem Detektor erfassten Strahlung abgetastet. Nach Identifikation der Codierung des zugehörigen Sendesignals (ASK, FSK, PSK, auch Abstands- oder Intervallmodulation genannt, etc.) eines empfangenen Signals, wird beispielsweise mittels Fouriertransformation oder aus einem definierten Verlaufspunkt des abgetasteten, digitalisierten und rekonstruierten Signals, wie den Wendepunkten, den Kurvenmaxima, oder integral mittels eines aus der Zeitinterpolation bekannten Optimum Filters, sehr genau eine Signallaufzeit ("Pulslaufzeit") bestimmt.

Alternativ oder zusätzlich zur Bestimmung der Pulslaufzeit erfolgt eine (schnelle) Abtastung oft auch hinsichtlich in Amplitude, Phase, Polarisation, Wellenlänge und/oder Frequenz codierten oder modulierten Impulsen oder Impulsfolgen.

Zum Beispiel wird beim Ansatz der zeitlich sehr präzisen Abtastung bzw. dem Sampling des zurückgestreuten Signals das vom Detektor erzeugte elektrische Signal mittels eines Analog-Digital-Wandlers ("Analog-Digital-Converter", ADC) in eine digitale Signalfolge umgewandelt. Dieses digitale Signal wird anschliessend meistens in Echtzeit weiter verarbeitet. In einem ersten Schritt wird diese Signalfolge durch spezielle digitale Filter dekodiert, also erkannt, und schliesslich die Lage einer ein Zeitintervall beschreibenden Signatur innerhalb der Signalfolge bestimmt. Beispiele für zeitauflösende Signaturen sind Schwerpunkt, Cosinus-Transformation oder beispielsweise amplitudennormierte FIR-Filter ("finite impulse response filter") mit einem von der Pulsform abgeleiteten Gewichtskoeffizientensatz. Um allfällige Distanzdrifts zu eliminieren wird eine entsprechende zeitauflösende Signatur auch mit einem internen Startsignal verglichen. Um irreversible Samplingfehler oder Quantisierungsfehler zu vermeiden, werden zusätzliche dem Fachmann bekannte digitale Signal-Transformationen angewendet.

Eine der einfachsten Modulationsarten ist die Kennzeichnung der einzelnen Impulse oder der Pulsfolgen per Abstandscodierung, wie z.B. beschrieben in der EP 1 832 897 B1. Diese wird beispielsweise zu dem Zwecke der Re-Identifizierbarkeit eingesetzt. Diese Wiedererkennung ist dann erforderlich, wenn eine Mehrdeutigkeit entsteht, welche bei der Laufzeitmessung von Impulsen durch unterschiedliche Situationen hervorgerufen werden kann, beispielsweise wenn sich zwischen Vermessungsgerät und Zielobjekt mehr als ein Impuls oder eine Impulsgruppe befindet. Insbesondere vorteilhaft ist die Pulskodierung bei Mehrstrahlsystemen bestehend aus mehreren Laserstrahlen und zugeordneten Empfangssensoren. Die US 2016/084651 A1 offenbart eine Totalstation mit APD-Flächendetektor.

Eine Totalstation aus dem Stand der Technik weist beispielsweise eine Basis und eine Stütze auf, wobei die Stütze um eine erste Drehachse drehbar auf der Basis befestigt ist. Ferner weist die Totalstation beispielsweise einen Träger auf, der um eine zur ersten Drehachse im Wesentlichen orthogonale zweite Drehachse drehbar an der Stütze befestigt ist, wobei der Träger einen optischen Distanzmesser zur Messung einer Distanz zum Ziel mittels eines Distanzmessstrahls aufweist. Der Träger weist ferner eine, beispielsweise gemeinsame, Aus- und Eintrittsoptik für den ausgesendeten Distanzmessstrahl (Sendestrahl) und zugehörige zurückkommende Teile des Distanzmessstrahls (Empfangsstrahl) auf. Alternativ kann der Träger auch eine separate Eintrittsoptik und eine separate Austrittsoptik aufweisen.

Typischerweise wird zur zweidimensionalen Ausrichtung des Distanzmessstrahls auf ein Ziel sowohl die Stütze wie auch der Träger bewegt, wobei für eine spezielle Vermessungsaufgabe beispielsweise für jeden Messvorgang mindestens eine Bewegung der Stütze oder des Trägers notwendig ist. Stütze und Träger sind oft vergleichsweise schwere und somit träge Bauteile, weshalb die Abtastgeschwindigkeit im Rahmen einer Vermessungsaufgabe entsprechend limitiert ist.

Um die Abtastrate zu erhöhen, weist der Träger deshalb beispielsweise ein zusätzliches schnelles Ablenkelement auf, zur schnellen Ablenkung des ausgehenden Distanzmessstrahls gegenüber dem Träger. Somit kann also eine schnelle Bewegung des zur Messung benötigten Strahlenbündels des Distanzmessstrahls innerhalb des Erfassungsbereichs der Eintrittsoptik erwirkt werden, ohne hierfür die sonst notwendige Bewegung der grösseren (trägen) Komponenten zu erfordern. Es können aber auch Stütze, Träger und das zusätzliche schnelle Ablenkelement (oder mehrere zusätzliche schnelle Ablenkelemente) gleichzeitig und mit unterschiedlichen Geschwindigkeiten, Beschleunigungen und Bahnkurven bewegt werden, wobei beispielsweise die schnellen mit Beschleunigung behafteten Bewegungen mit dem mindestens einen schnellen Ablenkelement ausgeführt werden.

Das schnelle Ablenkelement kann in Form eines bewegten Spiegels oder alternativ auch durch andere, zur gesteuerten Winkelablenkung von optischer Strahlung geeignete Elemente, wie beispielsweise verdrehbare Prismen, bewegliche Lichtleiter, lichtbrechende optische Elemente, verformbare optische Komponenten, etc. realisiert werden. Die Messung erfolgt meist unter Bestimmung von Entfernung und Winkeln, also in Kugelkoordinaten, welche zur Darstellung und Weiterverarbeitung auch in kartesische Koordinaten transformiert werden können.

Die Strahlengänge für die Sende- und Empfangsstrahlung können derart ausgebildet sein, dass das Ablenkelement lediglich auf die Sendestrahlung wirkt, d.h. dass die abbildende Wirkung des Empfangskanals im Wesentlichen unabhängig ist von der Ansteuerung eines Ablenkelements, dass der Sendekanal und der Empfangskanal jeweils ein eigenes, beispielsweise separat ansteuerbares, Ablenkelement aufweisen, oder dass ein einzelnes Ablenkelement sowohl auf die Sendestrahlung wie auch auf die Empfangsstrahlung wirkt.

Wenn das Ablenkelement nur auf die Sendestrahlung wirkt, hat dies beispielsweise den Nachteil, dass durch den variierenden Einfallswinkel des Empfangsstrahls die Abbildungsposition der Empfangsstrahlung auf dem Empfänger variiert und deshalb eine grössere Empfängerfläche notwendig ist, als wenn beispielsweise die Abbildungsposition mittels entsprechender Optik stabilisiert wird. Durch die grössere Empfängerfläche wird jedoch auch der Hintergrundlichtanteil erhöht, was beispielsweise aufgrund von Schrotrauschen zu einem verschlechterten Signal-Rausch Verhältnis führt.

Der Hintergrundlichtanteil kann beispielsweise durch eine geeignete Wahl der Wellenlänge der Sendestrahlung und den Einbau von entsprechenden Filtern im Empfangspfad reduziert werden. Dies erhöht jedoch typischerweise die Komplexität der Lichtquelle, da diese eine definierte und stabile Wellenlänge aufweisen muss. Dies ist aufwendig, braucht besondere Stabilisierungsmassnahmen und verhindert dabei beispielsweise auch eine kompaktere Bauweise des Vermessungsgeräts.

Insbesondere für Messaufgaben, wo grössere Raumwinkelbereiche abgetastet werden sollen, eignen sich das mindestens eine oder die mehreren zusätzlichen schnellen Ablenkelemente um das Gesichtsfeld zu erweitern oder Winkelbereiche zwischen den Bahnen der trägen Bewegungsachsen mit weiteren Punkten zu füllen. Dadurch können dichte Punktwolken mit hoher Geschwindigkeit erzeugt werden. Das schnelle Ablenkelement, resp. mehrere schnelle Ablenkelemente, ist deshalb oft derart angeordnet, dass ein für Sende- und Empfangskanal gemeinsames Ablenkelement eingebaut ist oder für Sende- und Empfangskanal zwei separate Strahllenkelemente eingebaut sind.

Um den Empfänger klein zu halten und dadurch beispielsweise wiederum den Umgebungslichtanteil zu reduzieren, sind im Stand der Technik verschiedene Verfahren bekannt, beispielsweise basierend auf einer optischen Nachführung des Empfangskanals. Optische Nachführung ist bei Scanneranwendungen bekannt, da bei grossen Distanzen und/oder schnellen Scanbewegungen zwischen dem Zeitpunkt der Abstrahlung des Messstrahls und des Empfangs des am Objekt reflektierten Lichts sich die Ausrichtung der Vorrichtung weiter bewegt. Würde auf eine Winkelnachführung der Empfängerausrichtung verzichtet, so müsste ein Empfänger mit grosser Fläche eingesetzt werden. Die einzelnen Lösungen erfordern jedoch jeweils immer einen Kompromiss hinsichtlich Geräteparametern wie beispielsweise Gerätegrösse, Systemkomplexität, Ablenkgeschwindigkeit, Messgenauigkeit, messbarer Distanzbereich, oder Flexibilität hinsichtlich einstellbaren Abtastmustern.

Die Aufgabe der Erfindung besteht in der Bereitstellung einer Totalstation oder eines Theodoliten, womit die aus dem Stand der Technik bekannten Nachteile vermieden werden, insbesondere wobei schnelle und präzise Messungen über einen ausgedehnten Distanzmessbereich ermöglicht werden.

Diese Aufgabe wird durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die Erfindung betrifft eine Totalstation oder einen Theodoliten zum Erfassen einer Position eines Ziels, aufweisend eine Strahlungsquelle zur Erzeugung einer Sendestrahlung, z.B. gepulste Lasermessstrahlung, eine Basis, eine Stütze, die um eine erste Drehachse drehbar auf der Basis befestigt ist, und einen Träger, der um eine zur ersten Drehachse im Wesentlichen orthogonale zweite Drehachse drehbar an der Stütze befestigt ist. Dabei weist der Träger eine Austrittsoptik zum Aussenden eines durch zumindest einen Teil der Sendestrahlung bereitgestellten eine Anzielachse definierenden Distanzmessstrahls auf sowie ein einstellbares Strahllenkelement das konfiguriert ist zum Ablenken des Distanzmessstrahls so dass die Anzielachse gegenüber dem Träger definiert variierbar ist und einen Empfänger mit einer Gesamtdetektorfläche, wobei der Empfänger konfiguriert ist zum Erfassen von Distanzmessdaten basierend auf zumindest einem auf den Empfänger auftreffenden Teil des zurückkommenden Distanzmessstrahls, nachfolgend Empfangsstrahlung genannt. Die Totalstation oder der Theodolit weist zudem einen Stützen-Winkelencoder auf zum Erfassen von ersten Winkeldaten bezüglich einer Drehung der Stütze um die erste Drehachse sowie einen Träger-Winkelencoder zum Erfassen von zweiten Winkeldaten bezüglich einer Drehung des Trägers um die zweite Drehachse. Ferner weist die Totalstation oder der Theodolit einen Winkelbestimmer auf zum Erfassen von dritten Winkeldaten bezüglich der Ausrichtung der Anzielachse gegenüber dem Träger sowie eine Recheneinheit, die konfiguriert ist zum Ableiten der Position des Ziels basierend auf den Distanzmessdaten sowie den ersten, den zweiten, und den dritten Winkeldaten.

Gemäss der vorliegenden Erfindung ist die Totalstation oder der Theodolit konfiguriert, dass eine Einstellung eines Teilbereichs der Gesamtdetektorfläche als ein aktiver Erfassungsbereich erfolgt, wobei der aktive Erfassungsbereich bezüglich seiner Position auf der Gesamtdetektorfläche zeitlich variabel einstellbar ist, insbesondere wobei der aktive Erfassungsbereich ferner in seiner Form und/oder seinem Ausmass einstellbar ist, und wobei durch auf die Gesamtdetektorfläche auftreffende Empfangsstrahlung ein von der Einstellung des aktiven Erfassungsbereichs abhängiges Empfängersignal erzeugt wird. Ferner weist die Totalstation oder der Theodolit eine Steuerelektronik auf, wobei die Steuerelektronik konfiguriert ist zur fortlaufenden Einstellung des aktiven Erfassungsbereichs, abgestimmt auf die Ansteuerung des Strahllenkelements, und um basierend auf dem Empfängersignal die Distanzmessdaten abzuleiten.

Gemäss einer Ausführungsform weist der Empfänger empfangsstrahlungsseitig ein für die Empfangsstrahlung strahlungsundurchlässiges Blockierelement auf, wobei das Blockierelement derart konfiguriert ist, dass ein zeitlich variabel einstellbarer Durchlassbereich zum Durchlassen der Empfangsstrahlung zur Gesamtdetektorfläche eingestellt wird, wobei die Position des Durchlassbereichs bezüglich der Gesamtdetektorfläche einstellbar ist, insbesondere wobei der Durchlassbereich ferner bezüglich seiner Form und/oder seinem Ausmass einstellbar ist.

Zum Beispiel kann das Blockierelement ausgebildet sein basierend auf einer zur Gesamtdetektorfläche im Wesentlichen parallel angeordneten einstellbar rotierbaren Scheibe aus für die Empfangsstrahlung strahlungsundurchlässigem Material die eine für die Empfangsstrahlung strahlungsdurchlässige Öffnung aufweist. Beispielsweise können die Öffnungen und die Rotationsgeschwindigkeiten von zwei ineinander greifenden Scheiben derart ausgebildet respektive eingestellt werden, dass der aktive Erfassungsbereich jeweils derart einstellbar ist, dass unterschiedliche Erfassungsbereiche eine zweidimensionale virtuelle Bewegung über die Detektorfläche definieren.

Der Empfänger kann beispielsweise als eine grossflächige Photodiode ausgebildet sein, wobei erfindungsgemäss jeweils die effektive Detektionsfläche der Photodiode mittels des Blockierelements im Wesentlichen auf den auf der Gesamtdetektorfläche abgebildeten lateralen Querschnitt des Distanzmessstrahls eingeschränkt wird. Dadurch wird also erfindungsgemäss jeweils die von der Senderichtung des Distanzmessstrahls abhängige Lage der auf der Photodiode abgebildeten Empfangsstrahlung berücksichtigt und störendes Umgebungslicht (lateral zum Empfangsstrahl) unterdrückt.

Die Lage und/oder Form des auf die Gesamtdetektorfläche abgebildeten Empfangsstrahls kann ferner von der Distanz zum Ziel abhängen, beispielsweise bei Verwenden einer Fixfokusoptik im Empfangskanal der Totalstation oder des Theodoliten.

Insbesondere ist die Steuerelektronik deshalb konfiguriert zur Synchronisation der Ansteuerung des Strahllenkelements und der Einstellung des aktiven Erfassungsbereichs basierend auf mindestens einem von folgendem: den dritten Winkeldaten, einer Distanz zum Ziel, und einer Signallaufzeit zum Ziel.

Alternativ oder zusätzlich zu einem wie vorangehend beschriebenen mechanischen Blockieren des (lateralen) Umgebungslichts kann der Empfänger gemäss einer weiteren Ausführungsform ferner einen optoelektronischen Sensor basierend auf einer Anordnung von Mikrozellen aufweisen, insbesondere wobei der Sensor ausgebildet ist als Anordnung von Single Photon Avalanche Photodioden, wobei der Sensor eine Vielzahl von Mikrozellen aufweist und derart konfiguriert ist, dass die Mikrozellen einzeln und/oder in Mikrozellengruppen auslesbar sind und dadurch einzeln auslesbare Teilbereiche des Empfängers einstellbar sind, und wobei die Steuerelektronik konfiguriert ist zum fortlaufenden Einstellen von unterschiedlichen jeweils den aktiven Erfassungsbereich definierenden Teilbereichen.

Der Sensor kann beispielsweise eine Anordnung von Single Photon Avalanche Photodioden sein. Anordnungen von Single Photon Avalanche Photodioden, auch SPAD-Anordnung oder SPAD-Arrays genannt, sind in der Regel als Matrix-Struktur auf einem Chip angeordnet. Die Anordnungen oder Chips mit einer Photoempfindlichkeit im sichtbaren und nahen infraroten Spektralbereich werden auch als SiPM (Silicon Photomultiplier) bezeichnet. Die SiPM lösen allmählich die bisher eingesetzten Photomultiplier Tubes ab, insbesondere im sichtbaren und nahen ultravioletten Spektralbereich. SiPM haben eine hohe spektrale Empfindlichkeit im sichtbaren Wellenlängenbereich. Im Stand der Technik sind beispielsweise SPAD Arrays erhältlich, die bis in den Nahinfrarot-Bereich bis weit über 900 nm Wellenlänge sensitiv sind.

Das Besondere an diesen SPAD-Arrays ist deren hohe Verstärkung, weshalb diese bisher bei sehr schwachen optischen Signalen eingesetzt werden, wo lediglich 1 bis 50 Photonen auf den Sensor treffen. Solche, beispielsweise luftgestützten, Sensoren werden auch als SPL-LIDAR bezeichnet (SPL = "single photon lidar"). Bei nur wenigen Photonen ist das Distanzrauschen jedoch erheblich und beträgt typischerweise 10 mm bis 100 mm. Zudem wird die absolute Distanzmessgenauigkeit von der Signalstärke beeinflusst, dies insbesondere bei SPAD-Arrays mit wenigen Mikrozellen. Durch spezielle Massnahmen, beispielsweise eine Range Walk Kompensation, kann hingegen ein Distanzrauschen von weit weniger as 1 mm erreicht werden, wodurch eine Messgenauigkeit von 0.1 mm erreicht wird. Dies entspricht einer typischen Zeitauflösung von einer Pico-Sekunde oder weniger.

Kommerzielle SPAD-Arrays sind auch bei Wellenlängen zwischen 800 nm und 1800 nm erhältlich. Diese Sensoren bestehen hauptsächlich aus dem Halbleitermaterial InGaAs. Auch diese Sensoren weisen je nach Design eine externe oder interne Matrix-Struktur über die photo-sensitive Fläche auf. Distanzmesssysteme mit SPAD-Arrays in diesem Spektralbereich haben den Vorteil, dass das solare Umgebungslicht (Tageslicht) gegenüber dem sichtbaren Wellenlängenbereich erheblich niedriger ist und dass dadurch dieser störende Lichtstrom die SPAD-Arrays weniger stört.

Das Besondere dieser SPAD-Array-Sensoren ist die sehr hohe Photoempfindlichkeit, wobei die SPAD-Arrays hauptsächlich dazu ausgelegt sind, einzelne Photonen einwandfrei detektieren zu können. Deshalb werden sie auch als "Multi Pixel Photon Counter" (MPPC) bezeichnet. Die SPAD-Arrays bestehen aus hunderten, tausenden, bis über zehntausenden von Mikrozellen und sind so in der Lage, Pulse mit tausenden oder hundertausenden von Photonen gleichzeitig zu empfangen. Zudem sind aufgrund der Parallelschaltung der vielen Mikrozellen zu Zellengruppen (Domänen) auch bei solarem Hintergrundlicht nach wie vor ausreichend freie Zellen für die Signalphotonen vorhanden.

Eine weitere Besonderheit von SPAD-Anordnungen besteht insbesondere darin, dass einzelne Mikrozellen oder einzelne Subsets von Mikrozellen gesondert angesteuert und/oder gesondert ausgelesen werden können. Die Mikrozellen können also örtlich sequentiell aktiviert werden, beispielsweise für ein zeilen- oder spaltenweises Auslesen des Empfängers (z.B. als "Rolling Shutter" oder "Rolling Frame"). Insbesondere können also von der Senderichtung abhängige einzeln auslesbare Teilbereiche des Empfängers definiert werden.

Beispielsweise können die Teilbereiche derart definiert sein, dass sie jeweils eine räumliche Abfolge von benachbarten Mikrozellen repräsentieren, z.B. wobei jeder Teilbereich mindestens einer Zeile oder mindestens einer Spalte der SPAD-Anordnung entspricht. Die Teilbereiche können aber auch durch jeweils beabstandete Bereiche des Empfängers definiert sein, d.h. dass die einzelnen Teilbereiche keine zusammenhängende Abfolge von Mikrozellen repräsentieren.

Insbesondere können die einzelnen Teilbereiche derart definiert sein, dass sie sich gegenseitig zumindest teilweise überlappen.

Zum Beispiel können die Teilbereiche ferner derart aufeinander abgestimmt sein, dass durch eine Abfolge von Signalerfassungen durch einzelne Teilbereiche (Domänen) beispielsweise alternierend einzelne Mikrozellen oder Mikrozellengruppen der SPAD-Anordnung ausgelesen werden, beispielsweise alternierend gerade und ungerade Zeilen (bezüglich der SPAD-Anordnung) innerhalb der Teilbereiche. Eine solche zeitlich alternierende Aktivierung von Mikrozellen oder Mikrozellengruppen führt beispielsweise zu einer Verkürzung der Erholungszeit des SPAD-Arrays, wodurch eine schnellere Lasermodulation oder Schussrate möglich ist.

Anstatt die Mikrozellen oder Mikrozellengruppen (Domänen) der SPAD-Anordnung separat zu aktivieren, können diese in einem stationären Zustand aktiviert bleiben, um für die "Rolling Shutter" oder "Moving Frame" Funktion die Ausgänge der Mikrozellen oder Mikrozellengruppen (Domänen) synchron zur senderseitigen Scanningbewegung zu erfassen und auszuwerten. Dabei werden mittels einer elektronischen, beispielsweise auf dem SPAD-Array integrierten, Schaltung gerade die Mikrozellen oder Mikrozellengruppen (Domänen) mit dem Signalausgang verbunden, die zeitsynchron zu der Fläche des Objekts hin ausgerichtet sind, welche vom senderseitigen Laser angestrahlt wird. Bewegt sich die Scanbewegung des Lasers in die vertikale Richtung, dann verschiebt sich die wirksame empfangsseitige Domäne synchron in dieselbe Richtung, sodass das Gesichtsfeld (FoV, "Field-of-View") der aktiven Empfangseinheit die Laserpunkte auf dem Objekt zeitgerecht empfangen kann. Das jeweils aktive Field-of-View der Empfangseinheit ist beispielsweise im Winkelbereich so klein ausgelegt, dass es die rückgestreuten Empfangspulse noch vollständig einsehen und empfangen kann und dabei möglichst wenig störendes Umgebungslicht empfängt. Die Eingrenzung des Gesichtsfelds und damit die Minimierung der Anzahl der aktivierten Mikrozellen reduziert zudem auch die Rauschbeiträge von thermischen und kapazitiv bedingten Rauschquellen.

Im Gegensatz zu den vergleichsweise teuren Photomultiplier-Tubes mit grossem Zeitjitter, sind die modernen SiPM-Sensoren kostengünstig und haben Zeitjitter im Pikosekunden- bis Sub-Pikosekunden-Bereich. Zudem werden die SiPM-Arrays mittels eines konventionellen CMOS-Technologieprozesses gefertigt, was zusätzlich die Integration von elektronischen Bauteilen und Schaltungen ermöglicht. Für die SPAD-Arrays aus dem Halbleitermaterial InGaAs gilt Vergleichbares.

Die hohe Photoempfindlichkeit ist zurückzuführen auf den Avalanche-Mechanismus, wobei die einzelnen Mikrozellen des Arrays beispielsweise im Overvoltagebereich betrieben werden ("reverse voltage beyond the break voltage"), das heisst über der Durchbruchspannung (Breakspannung), bei welcher ein einzelnes Photon eine Lawine von Elektronen auslöst, wodurch das Signal je nach Einstellung stark verstärkt wird, z.B. eine Verstärkung bis zu einem Faktor von einer Million. Der dem Photon zugeordnete Strom ist wegen seiner Stärke leicht in ein Spannungssignal zu wandeln und ohne wesentliche Verstärkung einer Signalauswerteeinheit zuzuführen.

Ein SPAD-Array ist in der Lage mehrere Photonen gleichzeitig zu empfangen, wobei die Ströme der vielen Mikrozellen auf dem Sensorchip addiert werden können und anschliessend beispielsweise über einen Widerstand oder einen Transimpedanzverstärker in ein Spannungssignal gewandelt werden. Der SPAD-Array kann beispielsweise derart konfiguriert sein, z.B. mit mehr als zehntausend Mikrozellen, dass er sich wie ein analoger Photosensor verhält, wobei die Kennlinie beispielsweise bei schwachen Empfangssignalen annähernd proportional zur Intensität des einfallenden Laserimpulses ist.

In der Literatur wird unterschieden zwischen SPAD-Array Operationen im Linear-Modus, Geiger-Modus und SPL-Modus (SPL, "Single Photon Lidar").

Im Linear-Modus unterhalb der Durchbruchspannung tritt eine sperrspannungs- und temperaturabhängige Verstärkung auf und SPAD-Arrays können beispielsweise zum Aufbau hochempfindlicher Photoempfänger mit strahlungsleistungsproportionaler Ausgangsspannung verwendet werden.

Im Geiger-Modus und SPL-Modus, d.h. jeweils im Betrieb oberhalb der Durchbruchspannung können SPAD und SPAD-Arrays für die Einzelphotonzählung verwendet werden. Bei den SPADs erzeugt im Geiger-Modus jedes einzelne Pixel ein Ausgangssignal, wobei die Elektronenlawine durch genau ein Photon ausgelöst wird. Trifft ein Photonenpaket aus mehreren Photonen ein, so wird kein grösseres Signal gemessen, es ist daher keine Amplitudeninformation vorhanden.

Im Geiger-Modus erzeugt ein einfallendes Photonenpaket lediglich ein (binäres) Eventsignal, welches nicht proportional zur Anzahl Photonen im Photonenpaket ist.

Unter SPL-Modus versteht man einen im Geiger Mode betriebenen SPAD-Array, wo viele Mikozellen parallel zu einem Ausgangssignal geschaltet sind. Bei eintreffenden Photonenpaketen mit nur wenigen Photonen addieren sich die einzelnen Lawinen praktisch linear und die Amplitude des Ausgangssignals ist daher proportional zur Anzahl erfasster Photonen.

Bei der Laserdistanzmessung auf unterschiedliche Distanzen und variierende Oberflächen kann die Anzahl der Photonen beispielsweise variieren von weniger als 10 bis über 10⁹. SPAD-Arrays weisen demgegenüber einen Kompressionsfaktor der gemessenen Signalamplitude aus, der gegenüber der tatsächlichen Signalamplitude mindestens 10⁴, typischerweise 10⁸, beträgt. Mit SPAD-Arrays kann daher sowohl auf schwarze diffuse Targets als auch auf Retroreflektoren gemessen werden, ohne dass die Empfangseinheit eine Signalregelung benötigt. Durch die grosse Verstärkung weisen SPAD-Arrays zudem beispielsweise ein niedriges Rauschen auf und SPAD-Arrays mit hohem Füllfaktor zeigen ein für Distanzmessungen geeignetes Signal-Rausch-Verhältnis (SNR, "Signal-to-Noise-Ratio"). Je mehr Mikrozellen ein SPAD-Array aufweist, umso grösser ist das SNR.

Die Lasersignale eines Distanzmessers sind in der Regel mit einer Impulskodierung beaufschlagt. Typische Impulsraten sind zwischen kHz bis GHz. Experimente haben gezeigt, dass mit SPAD-Arrays bei Spannungen im Overbreakbetrieb solche Signale gut empfangen werden können. Auch Pulspakete (Bursts) sind eindeutig und beinahe rauschfrei mit SPAD-Arrays zu empfangen. Dies beispielsweise auch dann, wenn die Erholungszeit (Recovery Time) der Mikrozellen mit zehn Nanosekunden recht lang ist. Aufgrund des quasi-analogen Aufbaus von SPAD-Arrays kann auch ein beispielsweise durch Umgebungslicht präsenter Photostrom empfangen werden. Das Lasersignal ist dann dem elektrischen Photostrom des Umgebungslichts überlagert. Zum Beispiel wird der durch den Laserpuls erzeugte Stromstoss am Ausgang des SPAD-Arrays noch Hochpass gefiltert, damit die langsame hintere Signalflanke verkürzt wird. Der Ausgangsimpuls wird dadurch zu einem kurzen Signalimpuls, z.B. mit einer Pulsdauer kleiner als eine Nanosekunde. Solche kurzen Pulse mit steilen Flanken sind für eine präzise Zeit- und somit auch Distanzmessung geeignet. Die Verwendung eines Hochpassfilters (Differenzierers) hat jedoch keinen Einfluss auf die Erholungszeit des SPAD-Arrays.

Weiter wurden bereits erste Realisierungsversuche unternommen, um mehr elektronische Funktionalität in die SPAD-Arrays zu integrieren. Beispielsweise wurden bereits jeder Mikrozelle zugeordnete Zeitmesschaltungen ("TOFcircuitries"). Diese messen die Laufzeit (TOF, "Time-of-Flight"). Es existieren zum Beispiel SPAD-Array Implementierungen, wobei nahe bei den Mikrozellen eine präzise Photonenzählung integriert ist, die ohne einen nachgeschalteten Analog-Digital-Wandler (ADC, "Analog-Digital-Converter") auskommt. Zudem kann beispielsweise bei jeder Mikrozelle je eine Zeitmesschaltung (TDC, "time to digital converter") integriert sein. Als Ausgang des SPAD-Arrays wird ferner beispielsweise ein digitales Interface verwendet. Solche Bausteine sind voll digital und brauchen kein "mixed signal processing" bei der CMOS-Herstellung. Erfindungsgemäss werden also abhängig von der Senderichtung der Sendestrahlung richtungsabhängige Teilbereiche des Empfängers eingestellt, um die aktive Empfängerfläche mechanisch und/oder elektronisch auf eine variierende Abbildungsposition der Empfangsstrahlung auf der Gesamtdetektorfläche abzustimmen. Dadurch kann die jeweils genutzte Empfängerfläche bezüglich des einfallenden Empfangsstrahls optimiert werden. Zum Beispiel kann die aktive Empfangsfläche im Wesentlichen auf den Strahldurchmesser des jeweiligen Empfangsstrahls abgestimmt sein. Somit kann der Hintergrundlichtanteil auch mit einem an sich bezüglich des Strahldurchmessers überdimensionierten Empfänger für eine Einzelmessung jeweils tief gehalten werden.

Gemäss einer weiteren Ausführungsform der Erfindung ist die Steuerelektronik konfiguriert zur Steuerung der Totalstation oder des Theodolits basierend auf einem vorprogrammierten Messvorgang, wobei durch den Messvorgang eine, insbesondere scannende, Abtastung mittels des Distanzmessstrahls durchgeführt wird und der Messvorgang eine erste und eine zweite Stufe aufweist, wobei die erste Stufe eine Bewegung der Stütze um die erste Drehachse und/oder eine Bewegung des Trägers um die zweite Drehachse definiert, und die zweite Stufe die Ansteuerung des Strahllenkelements und dadurch eine Bewegung des Distanzmessstrahls gegenüber dem Träger definiert. Die zweite Stufe ist dabei der ersten Stufe überlagert, wobei die Bewegung des Distanzmessstrahls verglichen mit den Bewegungen der Stütze und des Trägers mit einer höheren Geschwindigkeit erfolgt, und unterschiedliche aktive Erfassungsbereiche jeweils basierend auf den dritten Winkeldaten eingestellt werden, so dass jeweils zu unterschiedlichen Zeitpunkten eingestellte aktive Erfassungsbereiche jeweils in Richtung des jeweils zeitgerecht auf dem Ziel abgebildeten Distanzmessstrahls ausgerichtet sind. Bei Verwendung eines erfindungsgemässen optoelektronischen Sensors kann beispielsweise zu den jeweils unterschiedlichen Zeitpunkten lediglich der jeweils eingestellte einzeln auslesbare Teilbereich des Sensors mit dem Signalausgang des Sensors verbunden sein.

Im Speziellen werden die aktiven Erfassungsbereiche jeweils derart eingestellt, dass das jeweils durch einen aktiven Erfassungsbereich definierte (effektive) Gesichtsfeld des Empfängers den auf dem Empfänger abgebildeten Distanzmessstrahl derart umschliesst, dass das Verhältnis zwischen der auf dem jeweiligen aktiven Erfassungsbereich abgebildeten Fläche des Distanzmessstrahls zur Fläche des jeweiligen aktiven Erfassungsbereichs grösser ist als ein definierter Schwellwert.

Das senderseitige Strahllenkelement zum Ablenken des Distanzmessstrahls kann beispielsweise realisiert sein als ein bewegter Spiegel oder alternativ auch durch andere, zur gesteuerten Winkelablenkung von optischer Strahlung geeignete Elemente, wie beispielsweise verdrehbare Prismen, bewegliche Lichtleiter, lichtbrechende optische Elemente, akustooptische Modulatoren, elektrooptische Deflektoren, verformbare optische Komponenten, etc.

Empfängerseitig wird erfindungsgemäss also beispielsweise synchronisiert zur zweiten Stufe das (effektive) Field-of-View der Empfangseinheit nachgeführt. Diese Massnahme erfolgt beispielsweise dadurch, dass zu einem bestimmten Zeitpunkt lediglich eine Domäne (Untergruppe von Mikrozellen) eines SPAD-Arrays mit dem Signalausgang verbunden ist, welche genau in Richtung Lichtfleck auf dem Objekt/Ziel ausgerichtet ist. Da die Lichtflecke scanartig über das zu vermessende Objekt verschwenkt werden, wird die aktive Domäne des SPAD-Arrays in rein schaltungstechnischer Weise synchron über das Objekt verschwenkt. Diese aktive Domäne des SPAD-Arrays bildet das aktive Gesichtsfeld der Empfangseinheit. Dieses jeweils aktive Gesichtsfeld der Empfangseinheit ist absichtlich schmal ausgelegt, damit möglichst wenig Sonnenlicht eingefangen wird und möglichst wenige Mikrozellen der aktiven Domäne fehlgetriggert werden. Die aktivierten Teilbereiche des Empfängers bewegen sich synchron mit dem Lichtfleck über die Fläche des SPAD-Arrays und zwar so, dass die aktiven Mikrozellen den Lichtfleck teilweise oder ganz einschliessen. Durch dieses elektronische Scanning, auch "solid state scanning" genannt, braucht es auf der Empfangsseite keine beweglichen Teile wie MEMS-Scanner, Keil-Scanner, Polygonprismenrad oder Polygonspiegelrad.

Gemäss einer weiteren Ausführungsform weist der Träger einen optischen Empfangskanal zum Abbilden der Empfangsstrahlung auf den Empfänger auf, wobei der Empfangskanal derart konfiguriert ist, dass die abbildende Wirkung des Empfangskanals im Wesentlichen unabhängig ist von der Ansteuerung des Strahllenkelements, insbesondere wobei das Strahllenkelement derart angeordnet ist, dass es lediglich auf die Sendestrahlung wirkt. Dies bedeutet also, dass der Empfangskanal eine gegenüber dem Träger statische optische Achse hat, also keine optische Richtungskorrektur des einfallenden Empfangsstrahls erfolgt. Dadurch kann beispielsweise der optische Aufwand und die Mechanik des Empfangskanals vereinfacht werden, insbesondere auch wegen den grossen Bündeldurchmessern und den steilen Winkeln der Randstrahlen im Empfangskanal.

In einer weiteren Ausführungsform ist das Strahllenkelement derart konfiguriert, dass das Ablenken des Distanzmessstrahls derart erfolgt, dass der Distanzmessstrahl gegenüber dem Träger lediglich bezüglich zwei unterschiedlichen, insbesondere zueinander orthogonalen, Ablenkrichtungen abgelenkt wird.

Weiter ist es für Vermessungsaufgaben einer Totalstation oft ausreichend, wenn eine schnelle Abtastung lediglich entlang einer einzelnen Abtastrichtung erfolgt. Dies ermöglicht also ebenfalls eine vereinfachte und gegebenenfalls kompaktere Bauweise des Sende- und Empfangskanals.

Eine weitere Ausführungsform ist folglich dadurch gekennzeichnet, dass das Strahllenkelement derart konfiguriert ist, dass das Ablenken des Distanzmessstrahls derart erfolgt, dass der Distanzmessstrahl gegenüber dem Träger lediglich bezüglich einer einzelnen Ablenkrichtung abgelenkt wird, wodurch eine den Distanzmessstrahl enthaltende (aktuelle) Abtastebene bezüglich des Trägers definiert wird.

Zum Beispiel kann also gemäss einer weiteren Ausführungsform die Gesamtdetektorfläche eine längliche, insbesondere rechteckige, Form aufweisen, wodurch eine lange und eine kurze Empfängerachse definiert ist, wobei der Empfangskanal derart konfiguriert ist, dass die Abtastebene auf der Gesamtdetektorfläche entlang der langen Empfängerachse abgebildet wird.

Die Winkeldaten bezüglich der Ausrichtung der Zielachse werden durch die Steuerelektronik beispielsweise anhand von Steuersignalen für die Ansteuerung des Strahllenkelements abgeleitet und/oder basierend auf Winkelmessdaten, welche beispielsweise von einem oder mehreren in der Totalstation oder dem Theodolit vorhandenen Winkelmessern bereitgestellt werden.

Gemäss einer weiteren Ausführungsform, welche mindestens einen wie vorangehend beschriebenen opto-elektronischen Sensor mit einer Vielzahl von einzeln und/oder in Mikrozellengruppen auslesbaren Mikrozellen aufweist, ist die Totalstation oder der Theodolit konfiguriert um eine Auftreffposition der Empfangsstrahlung auf dem Empfänger abzuleiten, insbesondere mittels Schwerpunktbestimmung oder Maximumbestimmung der erfassten Empfangsstrahlung, und um basierend auf der Auftreffposition und den Distanzmessdaten eine Korrekturinformation bezüglich der dritten Winkeldaten abzuleiten.

Zum Beispiel kann somit eine genaue Referenzierung von Distanzmessdaten für eine Erstellung einer Punktwolke erzielt werden, wobei beispielsweise auf zusätzliche dem Strahllenkelement zugeordnete Winkelmesser im Messgerät verzichtet werden kann. Zum Beispiel kann es somit unter Umständen ausreichen, wenn die (initial) abgeleiteten Winkeldaten lediglich auf Steuersignalen für die Ansteuerung des Strahllenkelements basieren und die initial abgeleiteten Winkeldaten für die Referenzierung in einer Punktwolke basierend auf der Auftreffposition korrigiert werden.

In einer weiteren Ausführungsform ist die Totalstation oder der Theodolit konfiguriert, um basierend auf den dritten Winkeldaten eine erste Abbildungsinformation für eine Strahlform und/oder Lage der auf dem Empfänger abgebildeten Empfangsstrahlung abzuschätzen, insbesondere basierend auf einer definierten Fixfokusoptik, wobei der aktive Erfassungsbereich basierend auf der abgeschätzten ersten Abbildungsinformation eingestellt wird.

Zum Beispiel kann dazu die Totalstation oder der Theodolit konfiguriert sein, um basierend auf den dritten Winkeldaten einen Einfallswinkel der Empfangsstrahlung bezüglich des Empfangskanals der Totalstation oder des Theodoliten abzuleiten, wobei aus dem Einfallswinkel die erste Abbildungsinformation abgeleitet wird.

Gemäss einer weiteren Ausführungsform ist die Totalstation oder der Theodolit konfiguriert, um basierend auf einer Distanz zum Ziel eine zweite Abbildungsinformation für eine Strahlform und/oder Lage der auf dem Empfänger abgebildeten Empfangsstrahlung abzuschätzen, wobei der aktive Erfassungsbereich basierend auf der abgeschätzten zweiten Abbildungsinformation eingestellt wird. Dadurch können beispielsweise bei Messungen auf nahe Distanzen Nahfeldkorrekturen und Nahfeldeffekte der Empfangsoptik berücksichtigt werden.

Insbesondere kann gemäss einer weiteren Ausführungsform, welche mindestens einen wie vorangehend beschriebenen optoelektronischen Sensor mit einer Vielzahl von einzeln und/oder in Mikrozellengruppen auslesbaren Mikrozellen aufweist, die Totalstation oder der Theodolit konfiguriert sein, um basierend auf einem Feedback des Empfängers bezüglich vorgängig erfasster Empfangsstrahlung eine dritte Abbildungsinformation für eine Strahlform und/oder Lage der auf dem Empfänger abgebildeten Empfangsstrahlung abzuschätzen, wobei der den aktiven Erfassungsbereich definierende Teilbereich basierend auf der abgeschätzten dritten Abbildungsinformation eingestellt wird.

Weiter kann, gemäss einer weiteren Ausführungsform, der Empfänger mehrere Sensoren aufweisen, wobei die mehreren Sensoren eindimensional oder zweidimensional zueinander angeordnet sind, insbesondere wobei jeder Sensor eine separate Ansteuerelektronik und/oder Auswerteelektronik aufweist. Oft werden bei solchen Anordnungen von Sensoren, beispielsweise SPAD-Arrays, die einzelnen Arrays als Pixel bezeichnet, obwohl jedes dieser Pixel selber aus hunderten bis zehntausenden von Mikrozellen besteht.

Ferner ist der Empfänger, der mindestens einen wie vorangehend beschriebenen opto-elektronischen Sensor mit einer Vielzahl von einzeln und/oder in Mikrozellengruppen auslesbaren Mikrozellen aufweist, gemäss einer weiteren Ausführungsform derart ausgebildet, dass ein Satz von zeitlich parallel auslesbaren Teilbereichen definierbar ist, insbesondere wobei die Strahlungsquelle konfiguriert ist ein Bündel von parallel erzeugten unterschiedlich gerichteten und/oder beabstandeter Lasermessstrahlen zu erzeugen, wobei die Teilbereiche des Satzes von zeitlich parallel auslesbaren Teilbereichen dabei derart definiert werden, dass sie jeweils einem Lasermessstrahl des Bündels von Lasermessstrahlen zugeordnet sind. Dadurch kann beispielsweise eine Multibeam-Abtastung mit mehreren parallelen und/oder divergierender Lasermessstrahlen erfolgen.

Die erfindungsgemässe Totalstation oder der erfindungsgemässe Theodolit werden nachfolgend anhand von in den Zeichnungen schematisch dargestellten Ausführungsbeispielen rein beispielhaft näher beschrieben. Gleiche Elemente sind in den Figuren mit gleichen Bezugszeichen gekennzeichnet. Die beschriebenen Ausführungsformen sind in der Regel nicht massstabsgetreu dargestellt und sie sind auch nicht als Einschränkung zu verstehen.

Im Einzelnen zeigen
- Fig. 1:: eine erfindungsgemässe Totalstation mit einer zusätzlichen Ablenkung des Distanzmessstrahls gegenüber dem Träger;
- Fig. 2a-d:: schematische Illustration eines Strahlengangs einer erfindungsgemässen Verwendung eines SPADArrays als photosensitive Fläche eines Empfängers in einer Totalstation oder einem Theodoliten;
- Fig. 3a,b:: erfinderische Ausführungsformen ("Rolling Shutter Fenster") bezüglich der Definition der einzelnen von der Senderichtung abhängigen Teilbereiche eines SPAD-Arrays, z.B. a) eindimensional, b) zweidimensional;
- Fig. 4: weitere Ausführungsform einer erfindungsgemässen Totalstation, mit einem Ablenken des Distanzmessstrahls gegenüber dem Träger bezüglich lediglich einer einzelnen Ablenkrichtung;
- Fig. 5:: erfindungsgemässes Koordinatenmessinstrument mit zweistufigem Scanmechanismus basierend auf einem empfängerseitigen SPAD-Array;
- Fig. 6a,b:: lineare Multipixelanordnung bestehend aus mehreren SPAD-Arrays für einen grosswinkligen Scanbereich;
- Fig. 7: mechanisches Erzeugen von richtungsabhängigen Erfassungsbereichen des Empfängers abgestimmt auf Abbildungspositionen der Empfangsstrahlung auf der Detektorfläche.

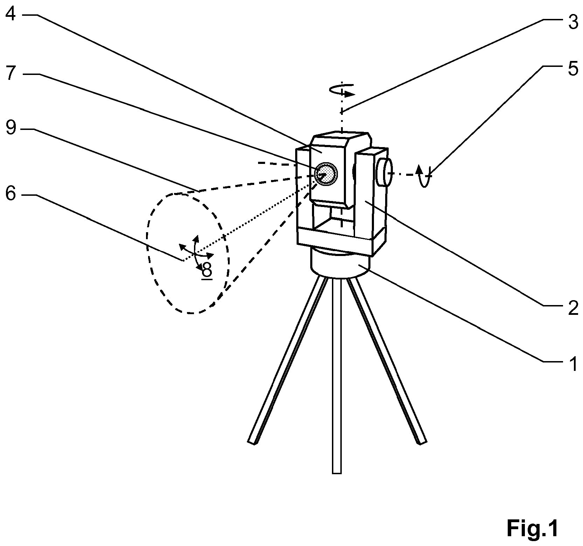

**Figur 1** zeigt eine erfindungsgemässe Totalstation mit einer zusätzlichen Ablenkung des Distanzmessstrahls gegenüber dem Träger.

Die Totalstation weist beispielsweise eine Basis 1 und eine Stütze 2 auf, wobei die Stütze 2 um eine erste Drehachse 3 drehbar auf der Basis 1 befestigt ist. Ferner weist die Totalstation einen Träger 4 auf, der um eine zur ersten Drehachse 3 im Wesentlichen orthogonale zweite Drehachse 5 drehbar an der Stütze 2 befestigt ist, wobei der Träger 4 einen optischen Distanzmesser zur Messung einer Distanz zum Ziel mittels eines Distanzmessstrahls 6 aufweist. Der Träger 4 weist ferner beispielsweise eine gemeinsame Aus- und Eintrittsoptik 7 für den ausgesendeten Distanzmessstrahl 6 (Sendestrahl) und zugehörige zurückkommende Teile des Distanzmessstrahls (Empfangsstrahl) auf. Alternativ kann der Träger auch eine separate Eintrittsoptik und eine separate Austrittsoptik aufweisen.

Typischerweise weisen Totalstationen ferner Richtmittel (nicht gezeigt) zur Ausrichtung der Anzielachse der Totalstation auf ein Ziel auf, beispielsweise ein Okular, eine Kamera mit Teleskopobjektiv oder eine automatische Zielerfassungseinheit. Ferner können Totalstationen für eine automatische Zielverfolgung ausgelegt sein, beispielsweise wobei ein Ziel durch emittierte Trackingstrahlung aktiv beleuchtet und anhand der zurückkommenden Strahlung identifiziert und verfolgt wird, zum Beispiel mittels Erfassen der Ablage des erfassten Trackingstrahls auf einer positionssensitiven Diode.

Zur zweidimensionalen Ausrichtung des Distanzmessstrahls 6 auf ein Ziel wird sowohl die Stütze 2 wie auch der Träger 4 bewegt, wobei für eine spezielle Vermessungsaufgabe beispielsweise für jeden Messvorgang mindestens eine Bewegung der Stütze 2 oder des Trägers 4 notwendig ist. Stütze 2 und Träger 4 sind oft vergleichsweise schwere und somit träge Bauteile, weshalb die Abtastgeschwindigkeit im Rahmen einer Vermessungsaufgabe entsprechend limitiert ist.

Um die Abtastrate zu erhöhen, weist der Träger 4 deshalb beispielsweise ein zusätzliches hinsichtlich Geschwindigkeit und Beschleunigung schnelles Ablenkelement auf, zur schnellen Ablenkung 8 des ausgehenden Distanzmessstrahls 6 gegenüber dem Träger 4. Somit kann also eine schnelle Bewegung des zur Messung benötigten Strahlenbündels des Distanzmessstrahls 6 innerhalb des Gesichtsfelds 9 der im Wesentlichen durch die Eintrittsoptik 7 definierten Empfangsoptik erwirkt werden, ohne hierfür die sonst notwendige Bewegung der grösseren (trägen) Komponenten zu erfordern.

Punkte ausserhalb des Gesichtsfelds der Empfangsoptik werden erfasst mittels eines kombinierten Bewegungsablaufs. Die langsamen oder trägen Bewegungen mit niedriger Beschleunigung erfolgen mittels Bewegung der Stütze 2 und Träger 4, wohingegen die schnellen Bewegungen mit hoher Geschwindigkeit und Beschleunigung senderseitig mit wenigstens einem schnellen zusätzlichen Ablenkelement im Träger 4 erfolgen.

Erfindungsgemäss ist der Empfänger des Distanzmessers beispielsweise basierend auf einem SPAD-Array ausgebildet, wobei die Ansteuerung des zusätzlichen schnellen Ablenkelements im Träger 4 und das Erfassen der Distanzmessdaten derart synchronisiert sind, dass basierend auf der Senderichtung der Distanzmessstrahlung 6 (Sendestrahlung) die Empfangsstrahlung basierend auf einem definierten Teilbereich des Empfängers erfasst wird. Es werden also abhängig von der Senderichtung der Sendestrahlung 6 richtungsabhängige Teilbereiche des Empfängers definiert, um die aktive Empfängerfläche auf eine variierende Abbildungsposition der Empfangsstrahlung abzustimmen. Dadurch kann die jeweils genutzte Empfängerfläche bezüglich des einfallenden Empfangsstrahls optimiert werden. Zum Beispiel kann die aktive Empfangsfläche im Wesentlichen auf den Strahldurchmesser (bezüglich des auf dem Empfänger abgebildeten Lichtflecks) des jeweiligen Empfangsstrahls abgestimmt sein, womit der Hintergrundlichtanteil auch mit einem an sich bezüglich des Strahldurchmessers überdimensionierten Empfänger für eine Einzelmessung jeweils tief gehalten werden kann.

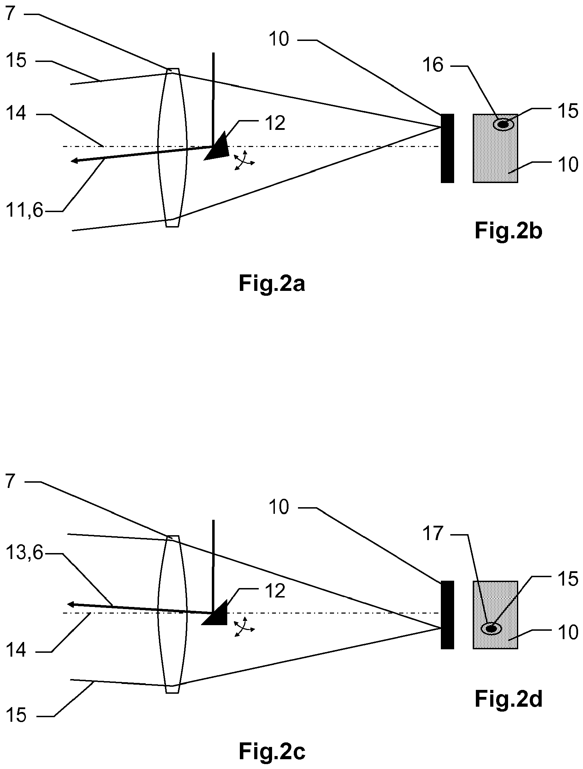

Die **Figuren 2a bis 2d** zeigen schematisch eine erfindungsgemässe Verwendung eines SPAD-Arrays 10 als photosensitive Fläche eines Empfängers. Die Figuren 2a,2b beziehen sich dabei auf eine erste Senderichtung 11, eingestellt durch ein Ablenkelement 12 welches im Wesentlichen nur auf die Sendestrahlung 6 wirkt, und die Figuren 2c,2d beziehen sich auf eine zweite Senderichtung 13, eingestellt durch das Ablenkelement 12. Die optische Achse des Empfangskanals ist also gegenüber dem Träger im Wesentlichen statisch.

**Figur 2a** zeigt aus einer Seitenansicht einen vereinfachten optischen Pfad für die erste Senderichtung 11, mit einer Hauptachse 14 einer gemeinsamen Aus-/Eintrittsoptik 7 und einem ein SPAD-Array 10 aufweisenden Empfänger. Das Ablenkelement 12 kann hier die Sendestrahlung 6 insbesondere eindimensional oder zweidimensional ablenken, d.h. entlang einer ersten und/oder zweiten Ablenkrichtung. Des Weiteren ist für einen Fachmann klar, dass je nach Typ des verwendeten Strahllenkelements 12, z.B. Spiegelelement, Prisma, Polygonrad, Doppelkeil, refraktives Element, bewegliche Lichtleiter oder MOEMS-Bauteil, und Wirkungsweise der dadurch erwirkten Strahlablenkung, z.B. Verschiebung/Verkippung des Ablenkelements oder elektrooptische Ansteuerung von optischen (z.B. refraktiven) Eigenschaften des Ablenkelements, dieses sowohl in einem parallelen wie auch in einem divergenten Strahlengang angeordnet sein kann.

**Figur 2b** zeigt in Draufsicht den Empfänger, respektive den SPAD-Array 10 aus Figur 2a. Erfindungsgemäss weist der SPAD-Array 10 eine Vielzahl von Mikrozellen auf und ist derart konfiguriert, dass die Mikrozellen einzeln und/oder in Mikrozellengruppen (Domänen) auslesbar sind und dadurch einzeln auslesbare Teilbereiche des SPAD-Arrays 10 definierbar sind. Die Ansteuerung des Ablenkelements 12 und das Erfassen des Empfangsstrahls 15 sind dabei derart synchronisiert, dass basierend auf der Senderichtung, hier der ersten Senderichtung 11, der Empfangsstrahl 15 basierend auf einem definierten Teilbereich des SPAD-Arrays 10 detektiert wird, hier einem ersten Teilbereich 16.

In analoger Weise zeigen die Figuren 2c (Seitenansicht) und 2d (Draufsicht) den optischen Pfad bezüglich der zweiten Senderichtung 13, wobei basierend auf der zweiten Senderichtung 13 ein zweiter Teilbereich 17 für das Erfassen des Empfangsstrahls 15 definiert ist.

Insbesondere können die jeweils definierten Teilbereiche 16,17 jeweils bezüglich der Strahlform des einfallenden Empfangsstrahls 15 optimiert werden. Zum Beispiel kann die Fläche des Teilbereichs im Wesentlichen auf den Strahldurchmesser des jeweiligen Empfangsstrahls 15 abgestimmt sein, wobei beispielsweise Veränderungen der Lichtfleckgrösse aufgrund von empfängerseitigen Blenden und Fixfokusoptik berücksichtigt werden. Somit kann der Hintergrundlichtanteil auch mit einem an sich bezüglich des Strahldurchmessers überdimensionierten Empfänger für eine Einzelmessung jeweils tief gehalten werden.

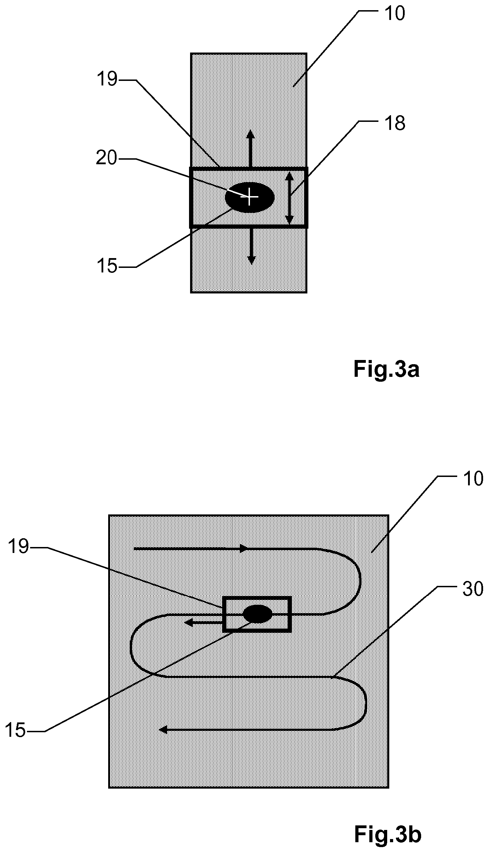

**Figur 3a** zeigt eine weitere erfinderische Ausführungsform, welche mindestens einen wie vorangehend beschriebenen optoelektronischen Sensor mit einer Vielzahl von einzeln und/oder in Mikrozellengruppen auslesbaren Mikrozellen aufweist, beispielsweise einen SPAD-Array 10. Die Teilbereiche werden hier ähnlich einem sogenannten "Rolling Shutter" oder "Moving Frame" Prinzip definiert, d.h. dass der ortsabhängige und über die Optik richtungsabhängig wirkende Teilbereich jeweils durch eine Kombination von mehreren SPAD-Zeilen definiert ist, wobei der Teilbereich ähnlich einem in der Höhe 18 veränderlichen Rolling Shutter Fenster 19 in einer Richtung senkrecht zu den SPAD-Zeilen, abhängig von der aktuellen Senderichtung, über den SPAD-Array 10 hin und her "rollt". Diese Definition von Teilbereichen hat beispielsweise den Vorteil einer vereinfachten Ansteuerungselektronik, wobei beispielsweise weiter die Höhe 18 des aktuellen Teilbereichs 19 an den Strahldurchmesser der Empfangsstrahlung 15 angepasst werden kann, z.B. als Funktion einer distanzabhängigen Veränderung der Lichtfleckgrösse.

Ein derart konfigurierter SPAD-Array ist zum Beispiel geeignet, wenn die Strahlablenkung durch das Ablenkelement 12 (siehe Fig.2a) im Wesentlichen eindimensional, d.h. entlang einer mit der "Rollrichtung" korrespondierenden Ablenkrichtung abgelenkt wird.

Weiter können die Totalstation und die SPAD-Anordnung 10 beispielsweise derart konfiguriert sein, dass eine Auftreffposition 20 der Empfangsstrahlung 15 auf dem Empfänger, resp. der SPAD-Anordnung 10, abgeleitet werden kann, z.B. mittels Schwerpunktbestimmung oder Maximumbestimmung des Empfangssignals. Durch die so abgeleitete Auftreffposition 20 kann der aktuelle Teilbereich 19 in Echtzeit noch fein an den Strahldurchmesser der Empfangsstrahlung 15 angepasst werden. Zudem kann basierend auf der abgeleiteten Auftreffposition 20 und den damit korrespondierenden Distanzmessdaten beispielsweise die zugehörige Senderichtung abgeleitet werden, beispielsweise um Winkeldaten bezüglich der Senderichtung, z.B. basierend auf Steuersignalen des Ablenkelements 12, zu überprüfen oder um allenfalls eine Korrekturinformation bezüglich der Winkeldaten abzuleiten.

**Figur 3b** zeigt die Empfangsfläche einer SPAD-Anordnung 10 mit einem von der Senderichtung abhängigen Teilbereich 19 der sich in zweidimensionaler Richtung verschiebt. Dargestellt ist die Bewegungsspur 30 des Lichtflecks 15 auf dem SPAD-Array 10 und damit der Bahn des Teilbereichs 19, also der aktiven Mikrozellen, die sich als Domäne in einer scannenden Bahn über die Fläche des SPAD-Arrays 10 bewegen. Hier sind die jeweiligen Teilbereiche einer Senderichtung der Sendeeinheit zugeordnet. Bewegt sich die Richtung des Sendestrahls beispielsweise in Form einer schlangenförmigen Linie 30 so bewegt sich der aktive Teilbereich 19 in ähnlicher Weise synchronisiert auf der SPAD-Anordnung 10. Auch hier ist ersichtlich, dass mittels des kleinen aktiven Teilbereichs das Hintergrundlicht vom Empfangskanal praktisch getrennt wird. Des Weiteren ist wegen der kleinen aktiven Empfangsfläche das Johnson-Rauschen und weitere flächenproportionale Elektronikrauschbeiträge reduziert.

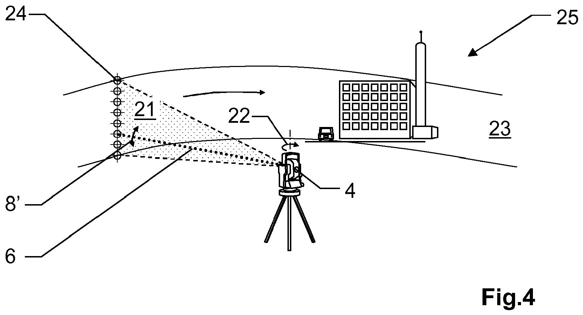

**Figur 4** zeigt eine weitere Ausführungsform einer erfindungsgemässen Totalstation, wobei hier das Ablenken des Distanzmessstrahls 6 derart erfolgt, dass der Distanzmessstrahl 6 gegenüber dem Träger 4 lediglich bezüglich einer einzelnen Ablenkrichtung abgelenkt wird, hier z.B. vertikal. Dadurch wird für eine aktuelle azimutale Ausrichtung der Stütze 2 (Fig. 1) eine für diese Ausrichtung aktuelle Abtastebene 21 bezüglich des Trägers 4 definiert, welche mögliche durch das Strahllenkelement 12 (siehe Fig. 2a) definierte Zielachsen enthält.

Insbesondere kann die Totalstation nun beispielsweise einen vorprogrammierten Messvorgang mit einer azimutalen Drehung 22 der Stütze um die erste Drehachse 3 (siehe Fig. 1) und einer Abtastung mittels eines Strahllenkelements 12 im Träger 4 aufweisen, wobei die Drehgeschwindigkeit der azimutalen Drehung 22 der Stütze 2 klein ist im Vergleich zur Ablenkrate der (eindimensionalen) Ablenkung 8' durch das Strahllenkelement 12.

Zum Beispiel kann also die durch den Sensor definierte Gesamtdetektorfläche eine längliche, insbesondere rechteckige, Form aufweisen, wodurch eine lange und eine kurze Empfängerachse definiert ist, und der Empfangskanal kann derart konfiguriert sein, dass die Abtastebene auf der Detektorfläche entlang der langen Empfängerachse abgebildet wird. Insbesondere kann der Erfassungsbereich hier beispielsweise ähnlich einem Rolling Shutter Fenster 19 (siehe Fig. 3) in einer Richtung senkrecht zu den Sensor-Zeilen (hier bezüglich der vertikalen Richtung), abhängig von der aktuellen Senderichtung, über den Sensor 10 auf und ab "rollen".

Durch die azimutale Drehung 22 und die Ablenkung 8' mittels des Strahllenkelements 12 wird durch den Distanzmessstrahl 6 ein zweidimensionales Abtastraster oder Abtastband 23 mit mehreren Abtastpunkten 24 abgefahren und beispielsweise automatisch abgetastet und schlussendlich eine 3D Punktwolke erzeugt.

Somit kann also beispielsweise ein rascher Abtastvorgang für eine automatische Abtastung einer Umgebung erfolgen, beispielsweise zur Erfassung eines Gebäudes 25 in der Umgebung.

Die Totalstation ist des weiteren beispielsweise in der Lage, einen vorprogrammierten Messvorgang bestehend aus einer Kombination einer azimutalen Drehung 22 der Stütze 2, einer vertikalen Bewegung des Trägers 4 und einer Abtastung mittels eines Strahllenkelements 12 im Träger 4 zu vollziehen. Die Drehgeschwindigkeiten und Beschleunigungen bezüglich der beiden Achsen 3 und 5 sind dabei klein im Vergleich zu den dynamischen Bewegungen des Strahllenkelements 12 zur Erzeugung der (eindimensionalen) Ablenkung 8'. Bei diesem Messvorgang sind nicht nur Panorama-Aufnahmen sondern beispielsweise ein Set von zonalen 360-Grad Aufnahmen möglich, die den gesamten Halbraum umfassen. Weitere Beispiele sind mäanderartige Bahnen, erzeugt durch Bewegung der Stütze 2 und des Trägers 4, um zusammen mit der schnellen Scanbewegung eine Szene in einem rechteckförmigen Gesichtsfeld mit beliebiger Winkelausdehnung mit homogener Punktverteilung in kurzer Messzeit aufzunehmen.

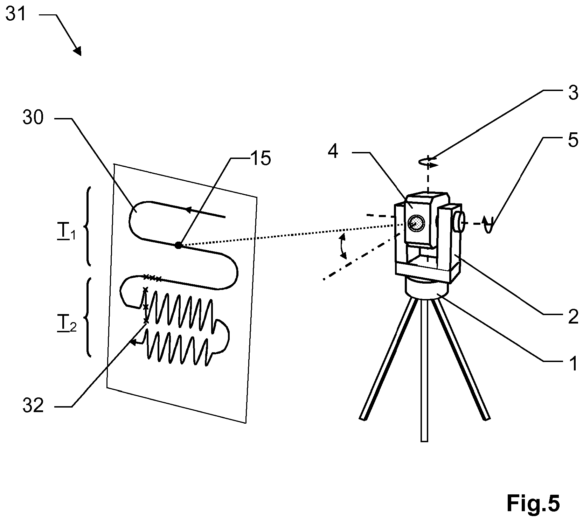

**Figur 5** zeigt eine erfindungsgemässe Totalstation. Die motorisierten orthogonalen Achsen des Instruments zum Drehen der Stütze 2 und des Trägers 4 bilden gewissermassen die erste Stufe eines Scan-Mechanismus, als zweite Stufe des Scan-Mechanismus wirkt das schnell scannende Ablenkelement im Träger 4 (nicht gezeigt), das den Sendstrahl mit hoher Geschwindigkeit und Beschleunigung zusätzlich abklenken kann.

Die Figur zeigt ferner schematisch ein Scanmuster 31 im Objektraum, dargestellt als Bewegungsspur 30 des Lichtflecks 15. Das Objekt wird hier als Abtastebene symbolisiert, worauf beispielsweise eine S-förmig abgetastete Bahn 30 entsteht. Im einem ersten Teil T₁ der Bahn werden lediglich die Stütze 2, resp. der Träger 4, um ihre jeweiligen Drehachsen 3,5 bewegt. In einem zweiten Teil T₂ der Bahn 30 hingegen wird mittels des sich schnell bewegenden Ablenkelements im Träger eine dichtere Flächenabdeckung erreicht. Dies bewirkt eine gleichmässigere Verteilung der Punktdichte auf der zu scannenden Objektfläche, insbesondere bei sehr hohen Distanzmessraten von mehr als 1 MHz.

Ohne das schnell scannende Ablenkelement würden die Messpunkte 32 dicht auf einer Linie der Bahn 30 zu liegen kommen, zwischen den Linien würden jedoch Messpunkte fehlen. Auf der Empfängerseite braucht es ebenfalls eine schnelle Nachführung des Gesichtsfelds. Mittels des erfinderischen Sensors wird, wie beispielsweise bezüglich den Figuren 3a,b beschrieben, ein zur Senderichtung zeitlich und räumlich synchronisierter aktiver Teilbereich des Sensors in eindimensionaler oder zweidimensionaler Richtung verschoben, sodass aus einer Gruppe von Mikrozellen das Signal der zugeordneten Laseremission zeitaufgelöst einer Distanzmessvorrichtung weitergeleitet werden kann.

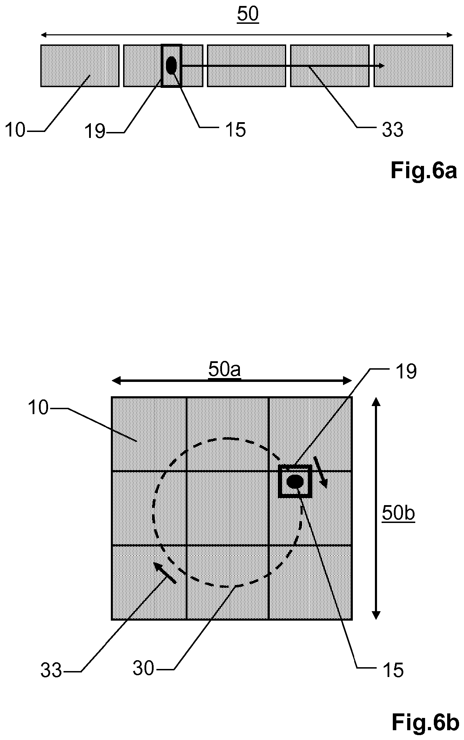

**Figuren 6a** und **6b** zeigen zwei weitere erfinderische Ausführungsformen einer Photosensoreinheit geeignet für sogenanntes "solid state scanning". In **Figur 6a** besteht die Photosensoreinheit aus mehreren in einer Linie angeordneten SPAD-Arrays 10. Diese Anordnung ist beispielsweise geeignet, um grössere Winkelbereiche im Objektraum abzuscannen. Der empfangene Laserspot 15 bewegt sich dabei über die mehreren SPAD-Arrays 10 hinweg. Der aktive Teilbereich 19 wird zeit- und orts-synchronisiert mit dem Empfangslichtfleck 15 bewegt, sodass das Messsignal effizient empfangen werden kann, aber gleichzeitig möglichst wenig Umgebungslicht pro Mikrozelle erfasst wird. Die Verschiebung des Teilbereichs 19 erscheint als virtuelle Bewegung 33 und ist in Pfeilrichtung angedeutet. Das erreichbare Field-of-View 50 der Empfangseinheit kann in einfacher Weise mittels der Anzahl von einzelnen SPAD-Arrays 10 dimensioniert werden.

In **Figur 6b** sind mehrere SPAD-Arrays 10 in einer zweidimensionalen Multipixel-Anordnung dargestellt. Jedes Pixel ist ein eigener SPAD-Array 10. Das erreichbare zweidimensionale Gesichtsfeld 50a,b ist hier beispielhaft definiert durch eine 3x3 Anordnung einzelner SPAD-Arrays 10. Damit die Gesamtdetektionsfläche keine Lücken aufweist, können beispielsweise SPAD-Arrays 10 ohne Randbereiche verwendet werden. In diesem Beispiel beschreibt die Bewegung des empfangenen Laserspots 10 eine Kreisbahn 30, wobei der aktive Teilbereich 19 den Laserspot 15 umschliesst und dermassen angesteuert wird, dass er sich mit dem Laserspot 15 entlang einer virtuelle Bewegung 33 bewegt.

Befindet sich die Mikrozellendomäne 19 vollständig auf einem einzelnen SPAD-Array 10, dann wird das Empfangssignal aller Mikrozellen beispielsweise innerhalb der Domäne an eine einzige Ausgangssignalleitung ausgegeben. Überdeckt hingegen die Mikrozellendomäne 19 zwei benachbarte SPAD-Arrays, dann werden beispielsweise zwei Ausgangssignalleitungen aktiviert, die dann ausserhalb der Multipixel-SPAD-Arrayanordnung über eine Multiplexerschaltung zusammengeführt werden. Es ist aber beispielsweise auch denkbar, dass diese Signalzusammenführungselektronik auf den SPAD-Array-Pixeln 10 (SPAD-Array-Chips) direkt implementiert sein kann.

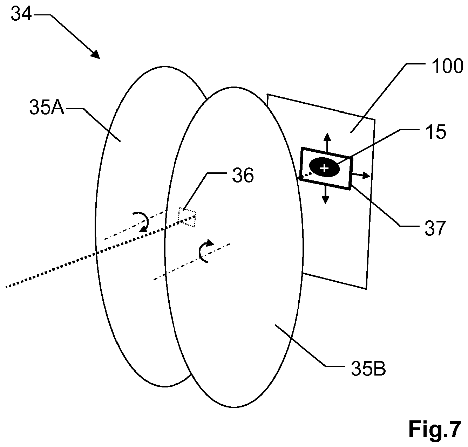

**Figur 7** zeigt schematisch einen Empfänger, der empfangsstrahlungsseitig ein für die Empfangsstrahlung strahlungsundurchlässiges einstellbares Blockierelement 34 aufweist, hier ausgebildet als zwei zur Gesamtdetektorfläche 100, beispielsweise einer grossflächigen Photodiode, im Wesentlichen parallel angeordneten einstellbar rotierbaren Scheiben 35A,35B aus für die Empfangsstrahlung 15 strahlungsundurchlässigem Material, welche jeweils definierte für die Empfangsstrahlung 15 strahlungsdurchlässige Öffnungen (nicht gezeigt) aufweisen.

Beispielsweise können die Öffnungen jeweils derart auf den beiden rotierenden Scheiben 35A,35B ausgebildet/kodiert sein, dass durch definierte Rotationseinstellungen der beiden Scheiben ein Satz von definierten Öffnungskombinationen einstellbar ist, so dass ein Satz einzelner definierter Durchlassbereiche 36 für eine Generierung einer endlichen Anzahl Erfassungsbereiche 37 der Detektorfläche 100 einstellbar sind. Alternativ können die Öffnungen beispielsweise auch derart ausgebildet sein, dass der durch die Rotation einer oder beider Scheiben definierte aktive Erfassungsbereich 37 der Gesamtdetektorfläche 100 eine zweidimensionale kontinuierliche Bewegung über die Gesamtdetektorfläche 100 vollzieht.

Die effektive Detektionsfläche der Photodiode wird also mittels Zusammenspiel der beiden Scheiben im Wesentlichen auf den auf der Gesamtdetektorfläche abgebildeten lateralen Querschnitt des Distanzmessstrahls eingeschränkt, so dass jeweils die von der Senderichtung des Distanzmessstrahls abhängige Lage der auf der Photodiode abgebildeten Empfangsstrahlung berücksichtigt und störendes Umgebungslicht (lateral zum Empfangsstrahl) unterdrückt wird.

Es versteht sich, dass diese dargestellten Figuren nur mögliche Ausführungsbeispiele schematisch darstellen. Die verschiedenen Ansätze können ebenso miteinander sowie mit Verfahren des Stands der Technik kombiniert werden.

## Patentansprüche

1. Totalstation oder Theodolit zum Erfassen einer Position eines Ziels, aufweisend
• eine Strahlungsquelle zur Erzeugung einer Sendestrahlung,
• eine Basis (1),
• eine Stütze (2), die um eine erste Drehachse (3) drehbar auf der Basis (1) befestigt ist,
• einen Träger (4), der um eine zur ersten Drehachse (3) im Wesentlichen orthogonale zweite Drehachse (5) drehbar an der Stütze (2) befestigt ist, wobei der Träger (4) aufweist
∘ eine Austrittsoptik zum Aussenden eines durch zumindest einen Teil der Sendestrahlung bereitgestellten eine Anzielachse (11,13) definierenden Distanzmessstrahls (6),
∘ ein einstellbares Strahllenkelement (12) das konfiguriert ist zum Ablenken des Distanzmessstrahls (6) so dass die Anzielachse (11,13) gegenüber dem Träger (4) mittels Ansteuerung des Strahllenkelements (12) definiert variierbar ist, und
∘ einen Empfänger mit einer Gesamtdetektorfläche (100), wobei der Empfänger konfiguriert ist zum Erfassen von Distanzmessdaten basierend auf zumindest einem auf den Empfänger auftreffenden Teil des zurückkommenden Distanzmessstrahls, nachfolgend Empfangsstrahlung (15) genannt,
• einen Stützen-Winkelencoder zum Erfassen von ersten Winkeldaten bezüglich einer Drehung der Stütze (2) um die erste Drehachse (3),
• einen Träger-Winkelencoder zum Erfassen von zweiten Winkeldaten bezüglich einer Drehung des Trägers (4) um die zweite Drehachse (5),
• einen Winkelbestimmer zum Erfassen von dritten Winkeldaten bezüglich der Ausrichtung der Anzielachse gegenüber dem Träger (4), und
• eine Recheneinheit, die konfiguriert ist zum Ableiten der Position des Ziels basierend auf den Distanzmessdaten sowie den ersten, den zweiten, und den dritten Winkeldaten,
**dadurch gekennzeichnet, dass**
• die Totalstation oder der Theodolit konfiguriert ist, dass eine Einstellung eines Teilbereichs der Gesamtdetektorfläche (100) als ein aktiver Erfassungsbereich (16,17,19,37) erfolgt, wobei
• der aktive Erfassungsbereich bezüglich seiner Position auf der Gesamtdetektorfläche (100) zeitlich variabel einstellbar ist, insbesondere wobei der aktive Erfassungsbereich (16,17,19,37) ferner in seiner Form und/oder seinem Ausmass einstellbar ist,
• durch auf die Gesamtdetektorfläche auftreffende Empfangsstrahlung ein von der Einstellung des aktiven Erfassungsbereichs abhängiges Empfängersignal erzeugt wird, und
• die Totalstation oder der Theodolit eine Steuerelektronik aufweist, wobei die Steuerelektronik konfiguriert ist zur fortlaufenden Einstellung des aktiven Erfassungsbereichs (16,17,19,37), abgestimmt auf die Ansteuerung des Strahllenkelements (12), und um basierend auf dem Empfängersignal die Distanzmessdaten abzuleiten.

2. Totalstation oder Theodolit nach Anspruch 1,
**dadurch gekennzeichnet, dass**
• der Empfänger empfangsstrahlungsseitig ein für die Empfangsstrahlung (15) strahlungsundurchlässiges Blockierelement (34) aufweist,
• das Blockierelement derart konfiguriert ist, dass ein zeitlich variabel einstellbarer Durchlassbereich (36) zum Durchlassen der Empfangsstrahlung (15) zur Gesamtdetektorfläche (100) eingestellt wird, wobei
• die Position des Durchlassbereichs (36) bezüglich der Gesamtdetektorfläche (100) einstellbar ist, insbesondere wobei der Durchlassbereich (36) ferner bezüglich seiner Form und/oder seinem Ausmass einstellbar ist.

3. Totalstation oder Theodolit nach Anspruch 2,
**dadurch gekennzeichnet, dass**
das Blockierelement (34) ausgebildet ist basierend auf einer zur Gesamtdetektorfläche (100) im Wesentlichen parallel angeordneten einstellbar rotierbaren Scheibe (35A,35B) aus für die Empfangsstrahlung (15) strahlungsundurchlässigem Material die eine für die Empfangsstrahlung (15) strahlungsdurchlässige Öffnung aufweist.

4. Totalstation oder Theodolit nach einem der vorhergehenden Ansprüche,
**dadurch gekennzeichnet, dass**
• der Empfänger einen optoelektronischen Sensor basierend auf einer Anordnung von Mikrozellen aufweist, insbesondere wobei der Sensor (10) ausgebildet ist als Anordnung von Single Photon Avalanche Photodioden,
• der Sensor (10) eine Vielzahl von Mikrozellen aufweist und derart konfiguriert ist, dass die Mikrozellen einzeln und/oder in Mikrozellengruppen auslesbar sind und dadurch einzeln auslesbare Teilbereiche des Empfängers einstellbar sind, und
• die Steuerelektronik konfiguriert ist zum fortlaufenden Einstellen von unterschiedlichen jeweils den aktiven Erfassungsbereich definierenden Teilbereichen (16,17,19).

5. Totalstation oder Theodolit nach einem der vorhergehenden Ansprüche,
**dadurch gekennzeichnet, dass**
die Steuerelektronik konfiguriert ist zur Synchronisation der Ansteuerung des Strahllenkelements (12) und der Einstellung des aktiven Erfassungsbereichs (16,17,19,37) basierend auf mindestens einem von
• den dritten Winkeldaten,
• einer Distanz zum Ziel, und
• einer Signallaufzeit zum Ziel.

6. Totalstation oder Theodolit nach einem der vorhergehenden Ansprüche,
**dadurch gekennzeichnet, dass**
der Träger einen optischen Empfangskanal zum Abbilden der Empfangsstrahlung (15) auf den Empfänger aufweist, wobei der Empfangskanal derart konfiguriert ist, dass die abbildende Wirkung des Empfangskanals im Wesentlichen unabhängig ist von der Ansteuerung des Strahllenkelements (12), insbesondere wobei das Strahllenkelement (12) derart angeordnet ist, dass es lediglich auf die Sendestrahlung wirkt.

7. Totalstation oder Theodolit nach einem der vorhergehenden Ansprüche,
**dadurch gekennzeichnet, dass**
das Strahllenkelement (12) derart konfiguriert ist, dass das Ablenken des Distanzmessstrahls (6) derart erfolgt, dass der Distanzmessstrahl (6) gegenüber dem Träger (4) lediglich bezüglich zwei unterschiedlichen, insbesondere zueinander orthogonalen, Ablenkrichtungen abgelenkt wird.

8. Totalstation oder Theodolit nach einem der vorhergehenden Ansprüche,
**dadurch gekennzeichnet, dass**
das Strahllenkelement (12) derart konfiguriert ist, dass das Ablenken des Distanzmessstrahls (6) derart erfolgt, dass der Distanzmessstrahl (6) gegenüber dem Träger (4) lediglich bezüglich einer einzelnen Ablenkrichtung abgelenkt wird, wodurch eine den Distanzmessstrahl (6) enthaltende Abtastebene (21) bezüglich des Trägers (4) definiert wird,
insbesondere wobei
• die Gesamtdetektorfläche (100) eine längliche, insbesondere rechteckige, Form aufweist, wodurch eine lange und eine kurze Empfängerachse definiert ist, und
• der Empfangskanal derart konfiguriert ist, dass die Abtastebene (21) auf der Gesamtdetektorfläche (100) entlang der langen Empfängerachse abgebildet wird.

9. Totalstation oder Theodolit nach einem der Ansprüche 4 bis 8,
**dadurch gekennzeichnet, dass**
der Sensor (10) derart konfiguriert ist, dass die einzelnen Teilbereiche (16,17,19) jeweils eine räumliche Abfolge von benachbarten Mikrozellen repräsentieren, insbesondere wobei jeder Teilbereich (16,17,19) mindestens einer Zeile oder mindestens einer Spalte des Sensors (10) entspricht.

10. Totalstation oder Theodolit nach einem der Ansprüche 4 bis 9,
**dadurch gekennzeichnet, dass**
die Totalstation oder der Theodolit konfiguriert sind
• um eine Auftreffposition (20) der Empfangsstrahlung (15) auf dem Empfänger abzuleiten, insbesondere mittels Schwerpunktbestimmung oder Maximumbestimmung der erfassten Empfangsstrahlung (15), und
• um basierend auf der Auftreffposition (20) und den Distanzmessdaten eine Korrekturinformation bezüglich der dritten Winkeldaten abzuleiten.

11. Totalstation oder Theodolit nach einem der vorhergehenden Ansprüche,
**dadurch gekennzeichnet, dass**
die Totalstation oder der Theodolit konfiguriert ist
• um basierend auf den dritten Winkeldaten eine erste Abbildungsinformation für eine Strahlform und/oder Lage der auf dem Empfänger abgebildeten Empfangsstrahlung (15) abzuschätzen, insbesondere basierend auf einer definierten Fixfokusoptik, und/oder
• um basierend auf einer Distanz zum Ziel eine zweite Abbildungsinformation für eine Strahlform und/oder Lage der auf dem Empfänger abgebildeten Empfangsstrahlung (15) abzuschätzen,
wobei der aktive Erfassungsbereich (16,17,19,37) basierend auf der abgeschätzten ersten und/oder zweiten Abbildungsinformation eingestellt wird.

12. Totalstation oder Theodolit nach einem der Ansprüche 4 bis 11,
**dadurch gekennzeichnet, dass**
die Totalstation oder der Theodolit konfiguriert ist um basierend auf einem Feedback des Empfängers bezüglich vorgängig erfasster Empfangsstrahlung (15) eine dritte Abbildungsinformation für eine Strahlform und/oder Lage der auf dem Empfänger abgebildeten Empfangsstrahlung (15) abzuschätzen, wobei der den aktiven Erfassungsbereich definierende Teilbereich (16,17,19) basierend auf der abgeschätzten dritten Abbildungsinformation eingestellt wird.

13. Totalstation oder Theodolit nach einem der Ansprüche 4 bis 12,
**dadurch gekennzeichnet, dass**
der Empfänger mehrere Sensoren (10) aufweist, wobei die mehreren Sensoren eindimensional oder zweidimensional zueinander angeordnet sind, insbesondere wobei jeder Sensor (10) eine separate Ansteuerelektronik und/oder Auswerteelektronik aufweist.

14. Totalstation oder Theodolit nach einem der vorhergehenden Ansprüche,
**dadurch gekennzeichnet, dass**
die Steuerelektronik konfiguriert ist zur Steuerung der Totalstation oder des Theodolits basierend auf einem vorprogrammierten Messvorgang, wobei durch den Messvorgang eine, insbesondere scannende, Abtastung mittels des Distanzmessstrahls (6) durchgeführt wird und der Messvorgang aufweist
• eine erste Stufe, welche eine Bewegung der Stütze (2) um die erste Drehachse (3) und/oder eine Bewegung des Trägers (4) um die zweite Drehachse (5) definiert, und
• eine zweite Stufe, welche die Ansteuerung des Strahllenkelements (12) und dadurch eine Bewegung des Distanzmessstrahls (6) gegenüber dem Träger (4)definiert,
wobei
• die zweite Stufe der ersten Stufe überlagert ist,
• die Bewegung des Distanzmessstrahls (6) verglichen mit den Bewegungen der Stütze (2) und des Trägers (4) mit einer höheren Geschwindigkeit erfolgt, und
• unterschiedliche aktive
Erfassungsbereiche (16,17,19,37) jeweils basierend auf den dritten Winkeldaten eingestellt werden, so dass jeweils zu unterschiedlichen Zeitpunkten eingestellte aktive Erfassungsbereiche (16,17,19,37) jeweils in Richtung des jeweils zeitgerecht auf dem Ziel abgebildeten Distanzmessstrahls (6) ausgerichtet sind, insbesondere wobei ein Sensor (10) nach einem der Ansprüche 4 bis 13 verwendet wird und zu den jeweils unterschiedlichen Zeitpunkten lediglich der jeweils eingestellte einzeln auslesbare Teilbereich des Sensors (10) mit dem Signalausgang des Sensors (10) verbunden ist,
insbesondere wobei die aktiven
Erfassungsbereiche (16,17,19,37) jeweils derart eingestellt werden, dass das jeweils durch einen aktiven Erfassungsbereich (16,17,19,37) definierte Gesichtsfeld des Empfängers den auf dem Empfänger abgebildeten Distanzmessstrahl (6) derart umschliesst, dass das Verhältnis zwischen der auf dem jeweiligen aktiven Erfassungsbereich (16,17,19,37) abgebildeten Fläche des Distanzmessstrahls (15) zur Fläche des jeweiligen aktiven Erfassungsbereichs (16,17,19,37) grösser ist als ein definierter Schwellwert.

15. Totalstation oder Theodolit nach einem der Ansprüche 4 bis 14,
**dadurch gekennzeichnet, dass**
der Empfänger derart ausgebildet ist, dass ein Satz von zeitlich parallel auslesbaren Teilbereichen (16,17,19) einstellbar ist,
insbesondere wobei die Strahlungsquelle konfiguriert ist,
• ein Bündel von parallel erzeugten unterschiedlich gerichteten und/oder beabstandeter Lasermessstrahlen zu erzeugen, und
• die Teilbereiche (16,17,19) des Satzes von zeitlich parallel auslesbaren Teilbereichen derart eingestellt werden, dass sie jeweils einem Lasermessstrahl des Bündels von Lasermessstrahlen zugeordnet sind.

## Claims

1. Total station or theodolite for acquiring a position of a target, having
• a radiation source for generating a transmitted radiation,
• a base (1),
• a support (2), which is fastened on the base (1) so it is rotatable about a first axis of rotation (3),
• a carrier (4), which is fastened on the support (2) so it is rotatable about a second axis of rotation (5), which is substantially orthogonal to the first axis of rotation (3), wherein the carrier (4) has
∘ an exit optical unit for emitting a distance measuring beam (6) provided by at least a part of the transmitted radiation and defining a targeting axis (11, 13),
∘ a settable beam deflection element (12), which is configured to deflect the distance measuring beam (6) in such a manner that the targeting axis (11, 13) is variable in a defined manner in relation to the carrier (4) by means of actuation of the beam deflection element (12), and
∘ a receiver comprising an overall detector surface (100), wherein the receiver is configured to acquire distance measurement data based on at least a part of the returning distance measuring beam incident on the receiver, referred to as received radiation (15) hereafter,
• a support angle encoder for acquiring first angle data with respect to a rotation of the support (2) about the first axis of rotation (3),
• a carrier angle encoder for acquiring second angle data with respect to a rotation of the carrier (4) about the second axis of rotation (5),
• an angle determining unit for acquiring third angle data with respect to the alignment of the targeting axis in relation to the carrier (4), and
• a computer unit, which is configured to derive the position of the target based on the distance measurement data and the first, the second, and the third angle data,
**characterized in that**
• the total station or the theodolite is configured such that a setting of a section of the overall detector surface (100) as an active acquisition region (16, 17, 19, 37) is carried out, wherein
• the active acquisition region is settable in a chronologically variable manner with respect to its position on the overall detector surface (100), in particular wherein the active acquisition region (16, 17, 19, 37) is furthermore settable in its shape and/or its dimensions,
• a receiver signal dependent on the setting of the active acquisition region is generated by received radiation incident on the overall detector surface, and
• the total station or the theodolite has a control electronics unit, wherein the control electronics unit is configured for the ongoing setting of the active acquisition region (16, 17, 19, 37), adapted to the actuation of the beam deflection element (12), and to derive the distance measurement data based on the receiver signal.

2. Total station or theodolite according to Claim 1, **characterized in that**
• the receiver has, on the received radiation side, a blocking element (34) which is radiation-opaque to the received radiation (15),
• the blocking element is configured such that a chronologically variable settable transmission region (36) is set to transmit the received radiation (15) to the overall detector surface (100), wherein
• the position of the transmission region (36) is settable with respect to the overall detector surface (100), in particular wherein the transmission region (36) is furthermore settable with respect to its shape and/or its dimensions.

3. Total station or theodolite according to Claim 2, **characterized in that**
the blocking element (34) is formed based on a settable rotatable disk (35A, 35B) arranged substantially parallel to the overall detector surface (100) made of material radiation-opaque for the received radiation (15), which has a radiation-transmissive opening for the received radiation (15).

4. Total station or theodolite according to any one of the preceding claims,
**characterized in that**
• the receiver has an optoelectronic sensor based on an assembly of microcells, in particular wherein the sensor (10) is designed as an assembly of single-photon avalanche diodes,
• the sensor (10) has a plurality of microcells and is configured such that the microcells can be read out individually and/or in microcell groups and sections of the receiver which can be read out individually are thus settable, and
• the control electronics unit is configured for the ongoing setting of different sections (16, 17, 19) respectively defining the active acquisition region.

5. Total station or theodolite according to any one of the preceding claims,
**characterized in that**
the control electronics unit is configured for the synchronization of the actuation of the beam deflection element (12) and the setting of the active acquisition region (16, 17, 19, 37) based on at least one of
• the third angle data,
• a distance to the target, and
• a signal runtime to the target.

6. Total station or theodolite according to any one of the preceding claims,
**characterized in that**
the carrier has an optical receiving channel for imaging the received radiation (15) on the receiver, wherein the receiving channel is configured such that the imaging effect of the receiving channel is substantially independent of the actuation of the beam deflection element (12), in particular wherein the beam deflection element (12) is arranged such that it solely acts on the transmitted radiation.

7. Total station or theodolite according to any one of the preceding claims,
**characterized in that**
the beam deflection element (12) is configured such that the deflection of the distance measuring beam (6) takes place such that the distance measuring beam (6) is deflected in relation to the carrier (4) only with respect to two different deflection directions, which are orthogonal to one another in particular.

8. Total station or theodolite according to any one of the preceding claims,
**characterized in that**
the beam deflection element (12) is configured such that the deflection of the distance measuring beam (6) takes place in such a manner that the distance measuring beam (6) is deflected in relation to the carrier (4) only with respect to a single deflection direction, whereby a scanning plane (21) containing the distance measuring beam (6) is defined with respect to the carrier (4),
in particular wherein
• the overall detector surface (100) has an oblong, in particular rectangular shape, whereby a long and a short receiver axis are defined, and
• the receiving channel is configured such that the scanning plane (21) is imaged on the overall detector surface (100) along the long receiver axis.

9. Total station or theodolite according to any one of Claims 4 to 8,
**characterized in that**
the sensor (10) is configured such that the individual sections (16, 17, 19) each represent a spatial sequence of adjacent microcells, in particular wherein each section (16, 17, 19) corresponds to at least one line or at least one column of the sensor (10).

10. Total station or theodolite according to any one of Claims 4 to 9,
**characterized in that**
the total station or the theodolite is configured
• to derive a position of incidence (20) of the received radiation (15) on the receiver, in particular by means of focal point determination or maximum determination of the acquired received radiation (15), and
• to derive an item of correction information with respect to the third angle data based on the position of incidence (20) and the distance measurement data.

11. Total station or theodolite according to any one of the preceding claims,
**characterized in that**
the total station or the theodolite is configured
• in order, based on the third angle data, to estimate a first item of imaging information for a beam shape and/or location of the received radiation (15) imaged on the receiver, in particular based on a defined fixed-focus optical unit, and/or
• in order, based on a distance to the target, to estimate a second item of imaging information for a beam shape and/or location of the received radiation (15) imaged on the receiver,
wherein the active acquisition region (16, 17, 19, 37) is set based on the estimated first and/or second item of imaging information.

12. Total station or theodolite according to any one of Claims 4 to 11,
**characterized in that**
the total station or the theodolite is configured, based on a feedback of the receiver with respect to previously acquired received radiation (15), to estimate a third item of imaging information for a beam shape and/or location of the received radiation (15) imaged on the receiver, wherein the section (16, 17, 19) defining the active acquisition region is set based on the estimated third item of imaging information.

13. Total station or theodolite according to any one of Claims 4 to 12,
**characterized in that**
the receiver has multiple sensors (10), wherein the multiple sensors are arranged one-dimensionally or two-dimensionally in relation to one another, in particular wherein each sensor (10) has a separate actuation electronics unit and/or analysis electronics unit.

14. Total station or theodolite according to any one of the preceding claims,
**characterized in that**
the control electronics unit is configured to control the total station or the theodolite based on a preprogrammed measuring procedure, wherein an in particular sweeping scanning is carried out by means of the distance measuring beam (6) by way of the measuring procedure and the measuring procedure has
• a first step, which defines a movement of the support (2) about the first axis of rotation (3) and/or a movement of the carrier (4) about the second axis of rotation (5), and
• a second step, which defines the actuation of the beam deflection element (12) and thus a movement of the distance measuring beam (6) in relation to the carrier (4),
wherein
• the second step is overlaid on the first step,
• the movement of the distance measuring beam (6) takes place at a higher speed in comparison to the movements of the support (2) and the carrier (4), and
• different active acquisition regions (16, 17, 19, 37) are respectively set based on the third angle data, and therefore respective active acquisition regions (16, 17, 19, 37) set at different points in time are each aligned in the direction of the respective distance measuring beam (6) imaged in a timely manner on the target, in particular wherein a sensor (10) according to any one of Claims 4 to 13 is used and at the respective different points in time, only the respective set section of the sensor (10), which can be individually read out, is connected to the signal output of the sensor (10),
in particular wherein the active acquisition regions (16, 17, 19, 37) are respectively set such that the respective field of view of the receiver defined by an active acquisition region (16, 17, 19, 37) encompasses the distance measuring beam (6) imaged on the receiver such that the ratio between the area of the distance measuring beam (15) imaged on the respective active acquisition region (16, 17, 19, 37) and the area of the respective active acquisition region (16, 17, 19, 37) is greater than a defined threshold value.

15. Total station or theodolite according to any one of Claims 4 to 14,
**characterized in that**
the receiver is designed such that a set of sections (16, 17, 19) which can be read out chronologically in parallel is settable,
in particular wherein the radiation source is configured,
• to generate a bundle of differently oriented and/or spaced-apart laser measuring beams generated in parallel, and
• the sections (16, 17, 19) of the set of sections which can be read out chronologically in parallel are set such that they are each associated with one laser measuring beam of the bundle of laser measuring beams.

## Revendications

1. Station totale ou théodolite pour détecter une position d'une cible qui présente
• une source de rayonnement pour générer un rayonnement d'émission,
• une base (1),
• un appui (2) qui est fixé rotatif autour d'un premier axe de rotation (3) sur la base (1),
• un support (4) qui est fixé sur l'appui (2) en étant rotatif autour d'un second axe de rotation (5) substantiellement orthogonal par rapport au premier axe de rotation (3), cependant que le support (4) présente
∘ une optique de sortie pour émettre un faisceau de mesure de distance (6) mis à disposition par au moins une partie du rayonnement d'émission et qui définit un axe de ciblage (11, 13),
∘ un élément réglable de déflexion de faisceau (12) qui est configuré pour dévier le faisceau de mesure de distance (6) si bien que l'axe de ciblage (11, 13) peut être varié de manière définie par rapport au support (4) au moyen de la commande de l'élément de déflexion de faisceau (12) et
∘ un récepteur avec une surface globale de détecteur (100), cependant que le récepteur est configuré pour détecter des données de mesure de distance sur la base d'au moins une partie du faisceau de mesure de distance de retour incident sur le récepteur, ci-dessous nommé rayonnement de réception (15),
• un codeur angulaire d'appui pour détecter des premières données d'angle par rapport à une rotation de l'appui (2) autour du premier axe de rotation (3),
• un codeur angulaire de support pour détecter des secondes données d'angle par rapport à une rotation du support (4) autour du second axe de rotation (5),
• un détermineur d'angle pour détecter des troisièmes données d'angle par rapport à l'alignement de l'axe de ciblage par rapport au support (4) et
• une unité de calcul qui est configurée pour dériver la position de la cible sur la base des données de mesure de distance ainsi que les premières, secondes et troisièmes données d'angle
**caractérisée en ce que**
• la station totale ou le théodolite est configuré de telle manière qu'un réglage d'une zone partielle de la surface globale de détecteur (100) est réalisé en tant que zone de détection active (16, 17, 19, 37) cependant que
• la zone de détection active est réglable de manière variable dans le temps pour ce qui est de sa position sur la surface globale de détecteur (100), en particulier cependant que la zone de détection active (16, 17, 19, 37) est de plus réglable quant à sa forme et/ou ses dimensions,
• qu'un signal de récepteur dépendant du réglage de la zone de détection active soit produit par le rayonnement de réception incident sur la surface globale de détecteur et
• la station totale ou le théodolite présente une électronique de commande, cependant que l'électronique de commande est configurée pour le réglage en continu de la zone de détection active (16, 17, 19, 37) en concordance avec la commande de l'élément réglable de déflexion de faisceau (12) et pour dériver les données de mesure de distance sur la base du signal de récepteur.

2. Station totale ou théodolite selon la revendication 1, **caractérisée en ce que**
• le récepteur présente, du côté du rayonnement de réception, un élément de blocage (34) imperméable au passage du rayonnement du rayonnement de réception (15),
• l'élément de blocage est configuré de telle manière qu'une zone de passage (36) réglable variable dans le temps est réglée pour faire passer le rayonnement de réception (15) vers la surface globale de détecteur (100) cependant que
• la position de la zone de passage (36) est réglable par rapport à la surface globale de détecteur (100), en particulier cependant que la zone de passage (36) est de plus réglable quant à sa forme et/ou ses dimensions.

3. Station totale ou théodolite selon la revendication 2, **caractérisée en ce que** l'élément de blocage (34) est configuré sur la base d'un disque (35A, 35B) rotatif de manière réglable, placé substantiellement parallèlement à la surface globale de détecteur (100), en matériau imperméable au passage du rayonnement pour le rayonnement de réception (15), disque qui présente une ouverture perméable au passage du rayonnement pour le rayonnement de réception (15).

4. Station totale ou théodolite selon l'une des revendications précédentes, **caractérisée en ce que**
• le récepteur présente un capteur optoélectronique sur la base d'un arrangement de microcellules, en particulier cependant que le capteur (10) est configuré comme arrangement de photodiodes à avalanche à photon unique (SPAD),
• le capteur (10) présente une multitude de microcellules et est configuré de telle manière que les microcellules peuvent être lues individuellement et/ou en groupes de microcellules et que des zones partielles du récepteur qui peuvent être lues individuellement sont ainsi réglables et
• l'électronique de commande est configurée pour le réglage en continu de différentes zones partielles (16, 17, 19) qui définissent respectivement la zone de détection active.

5. Station totale ou théodolite selon l'une des revendications précédentes, **caractérisée en ce que** l'électronique de commande est configurée pour la synchronisation de la commande de l'élément de déflexion de faisceau (12) et du réglage de la zone de détection active (16, 17, 19, 37) sur la base d'au moins l'un des éléments suivants
• les troisièmes données d'angle,
• une distance par rapport à la cible et
• un temps de propagation du signal par rapport à la cible.

6. Station totale ou théodolite selon l'une des revendications précédentes, **caractérisée en ce que** le support présente un canal de réception optique pour représenter le rayonnement de réception (15) sur le récepteur, cependant que le canal de réception est configuré de telle manière que l'effet reproducteur du canal de réception dépend substantiellement de la commande de l'élément de déflexion de faisceau (12), en particulier cependant que l'élément de déflexion de faisceau (12) est placé de manière à agir uniquement sur le rayonnement d'émission.

7. Station totale ou théodolite selon l'une des revendications précédentes, **caractérisée en ce que** l'élément de déflexion de faisceau (12) est configuré de telle manière que la déflexion du faisceau de mesure de distance (6) se fait de telle manière que le faisceau de mesure de distance (6) est dévié par rapport au support (4) uniquement pour ce qui est de deux directions de déflexion différentes, en particulier orthogonales l'une par rapport à l'autre.

8. Station totale ou théodolite selon l'une des revendications précédentes, **caractérisée en ce que** l'élément de déflexion de faisceau (12) est configuré de telle manière que la déflexion du faisceau de mesure de distance (6) se fait de telle manière que le faisceau de mesure de distance (6) est dévié par rapport au support (4) uniquement pour ce qui est d'une seule direction de déflexion si bien qu'un plan de balayage (21) qui contient le faisceau de mesure de distance (6) est défini par rapport au support (4), en particulier cependant que
• la surface globale de détecteur (100) présente une forme allongée, en particulier rectangulaire, si bien qu'un axe long de récepteur et un axe court de récepteur sont définis et
• le signal de réception est configuré de telle manière que le plan de balayage (21) est représenté sur la surface globale de détecteur (100) le long de l'axe long de récepteur.

9. Station totale ou théodolite selon l'une des revendications 4 à 8, **caractérisée en ce que** le capteur (10) est configuré de telle manière que les différentes zones partielles (16, 17, 19) représentent chacune une séquence spatiale de microcellules voisines, en particulier cependant que chaque zone partielle (16, 17, 19) correspond à au moins une ligne ou au moins une colonne du capteur (10).

10. Station totale ou théodolite selon l'une des revendications 4 à 9, **caractérisée en ce que** la station totale ou le théodolite est configuré
• pour dévier une position d'incidence (20) du rayonnement de réception (15) sur le récepteur, en particulier au moyen de la détermination du centre de gravité ou de la détermination du maximum du rayonnement de réception (15) détecté et
• pour dévier une information de correction pour ce qui est des troisièmes données d'angle sur la base de la position d'incidence (20) et des données de mesure de distance.

11. Station totale ou théodolite selon l'une des revendications précédentes, **caractérisée en ce que** la station totale ou le théodolite est configuré
• pour évaluer, sur la base des troisièmes données d'angle, une première information d'image pour une forme de faisceau et/ou la position du rayonnement de réception (15) représenté sur le récepteur, en particulier sur la base d'une optique à focale fixe définie et/ou
• pour estimer, sur la base d'une distance par rapport à la cible, une seconde information d'image pour une forme de faisceau et/ou la position du rayonnement de réception (15) représenté sur le récepteur,
cependant que la zone de détection active (16, 17, 19, 37) est réglée sur la base de la première et/ou de la seconde information d'image estimée.

12. Station totale ou théodolite selon l'une des revendications 4 à 11, **caractérisée en ce que** la station totale ou le théodolite est configuré pour évaluer, sur la base d'un feedback du récepteur pour ce qui est du rayonnement de réception (15) détecté de manière prioritaire, une troisième information d'image pour une forme de faisceau et/ou la position du rayonnement de réception représenté sur le récepteur, cependant que la zone partielle (16, 17, 19) qui définit la zone de détection active est réglée sur la base de la troisième information d'image évaluée.

13. Station totale ou théodolite selon l'une des revendications 4 à 12, **caractérisée en ce que** le récepteur présente plusieurs capteurs (10), cependant que les plusieurs capteurs sont placés de manière unidimensionnelle ou bidimensionnelle l'un par rapport à l'autre, en particulier cependant que chaque capteur (10) présente une électronique de commande et/ou une électronique d'évaluation séparée.

14. Station totale ou théodolite selon l'une des revendications précédentes, **caractérisée en ce que** l'électronique de commande est configurée pour la commande de la station totale ou du théodolite sur la base d'un processus de mesure préprogrammé, cependant qu'un balayage, en particulier par scannage, est exécuté par le processus de mesure au moyen du faisceau de mesure de distance (6) et le processus de mesure présente
• une première étape qui définit un mouvement de l'appui (2) autour du premier axe de rotation (3) et/ou un mouvement du support (4) autour du second axe de rotation (5) et
• une seconde étape qui définit la commande l'élément de déflexion de faisceau (12) et donc un mouvement du faisceau de mesure de distance (6) par rapport au support (4)
cependant que
• la seconde étape est superposée à la première étape,
• le mouvement du faisceau de mesure de distance (6) se fait avec une vitesse plus élevée comparée aux mouvements de l'appui (2) et du support (4) et
• différentes zones actives de détection (16, 17, 19, 37) sont réglées respectivement sur la base des troisièmes données d'angle si bien que des zones actives de détection (16, 17, 19, 37) réglées respectivement à différents moments sont orientées respectivement en direction du faisceau de mesure de distance (6) représenté respectivement en temps voulu sur la cible, en particulier cependant qu'un capteur (10) selon l'une des revendications 4 à 13 est utilisé et qu'aux différents moments seulement la zone partielle du capteur (10) pouvant être lue individuellement est reliée à la sortie de signal du capteur (10), en particulier cependant que les zones actives de détection (16, 17, 19, 37) sont réglées respectivement de manière que le champ visuel du récepteur défini par une zone active de détection (16, 17, 19, 37) enferme le faisceau de mesure de distance (6) représenté sur le récepteur de telle manière que le rapport entre la surface du faisceau de mesure de distance (15) représenté sur la zone active de détection respective (16, 17, 19, 37) et la surface de la zone active de détection respective (16, 17, 19, 37) est plus grand qu'un seuil défini.

15. Station totale ou théodolite selon l'une des revendications 4 à 14, **caractérisée en ce que** le récepteur est configuré de telle manière qu'un ensemble de zones partielles (16, 17, 19) pouvant être lues parallèlement dans le temps est réglable, en particulier cependant que la source de rayonnement est configurée
• pour générer un faisceau de rayons de mesure laser générés en parallèle orientés différemment et/ou espacés et
• les zones partielles (16, 17, 19) de l'ensemble de zones partielles pouvant être lues parallèlement dans le temps sont réglées de telle manière qu'elles sont associées respectivement à un rayon de mesure laser du faisceau de rayons de mesure laser.
